# EUROPEAN PATENT SPECIFICATION

(11) **EP 4 293 921 B1**
(45) Date of publication and mention of the grant of the patent: **12.11.2025**
(21) Application number: 23742173.0
(22) Date of filing: 28.04.2023
(51) Int. Cl.: H04B 1/401, H04B 1/04, H04B 1/00, H04B 1/40

(54) **FEM COMPRISING SWITCH, AND ELECTRONIC DEVICE COMPRISING SAME**
FRONTENDMODUL MIT SCHALTER UND ELEKTRONISCHE VORRICHTUNG DAMIT
MODULE FEM COMPRENANT UN COMMUTATEUR ET DISPOSITIF ÉLECTRONIQUE LE COMPRENANT

(30) Priority: 02.05.2022 KR 20220054488; 24.08.2022 KR 20220106489; 30.03.2023 KR 20230042108
(43) Date of publication of application: 20.12.2023
(73) Proprietor: Samsung Electronics Co., Ltd., Suwon-si, Gyeonggi-do 16677 (KR)
(72) Inventor: MOON, Yohan, Suwon-si, Gyeonggi-do 16677 (KR); NA, Hyoseok, Suwon-si, Gyeonggi-do 16677 (KR); YANG, Dongil, Suwon-si, Gyeonggi-do 16677 (KR); YOO, Jonghun, Suwon-si, Gyeonggi-do 16677 (KR)
(74) Representative: HGF
(86) International application number: PCT/KR2023/005923
(87) International publication number: WO 2023/214759

(56) References cited:
- EP-A1- 4 199 366
- CN-A- 110 504 982
- JP-A- 2020 167 446
- KR-A- 20200 034 551
- KR-A- 20200 044 569
- KR-A- 20220 025 516
- KR-A- 20220 025 516
- US-A1- 2018 351 457
- US-B2- 9 515 621

## Description

### [Technical Field]

The following descriptions relate to a front-end module (EFM) including a switch and an electronic device including the same.

### [Background Art]

Electronic devices are commonly required to support various frequency ranges. An electronic device supporting 5G network communication can support EN-DC (evolved universal mobile telecommunications system terrestrial radio access (EN-UTRA) new radio (NR) dual connectivity). An electronic device may include a plurality of power supply circuits for supplying a voltage to a power amplifier (PA) in a front-end module (FEM) in order to support dual connectivity.
US2018/0351457 A1 discloses a power management device including a first DC-DC converter coupled to a first output voltage line, a second DC-DC converter coupled to a second output voltage line, a first set of switches associated with the first DC-DC converter, and a second set of switches associated with the second DC-DC converter.

### [Disclosure]

### [Technical Problem]

An electronic device according to an example can provide a structure of power supply circuits capable of various connections in an operating frequency band in order to increase a degree of freedom for an antenna as well as reduce the number of power supply circuits with simplified structure of the power supply circuits.

The technical problems to be achieved in the present disclosure are not limited to those described above, and any other technical problems not mentioned herein will be clearly understood by those skilled in the art from the following description.

### [Technical Solution]

The present invention is defined by the appended claims.

### [Advantageous Effects]

An electronic device according to an example makes it possible to improve the connection structure of a power supply circuit that provides a voltage supplied to power amplifiers, thereby achieving further miniaturization of components in the electronic device as well as reducing the number of parts in the components in the electronic device.

The effects that can be obtained from the present disclosure are not limited to those described, and any other effects not mentioned herein will be clearly understood by those having ordinary knowledge in the art to which the present disclosure belongs, from the following description.

### [Description of the Drawings]

FIG. 1 is a block diagram of an electronic device in a network environment according to an example;
FIG. 2 is a block diagram of an electronic device for supporting legacy network communication and 5G network communication according to an example;
FIG. 3 is a schematic diagram illustrating a wireless communication system for providing a network of legacy communication and/or 5G communication according to an example;
FIG. 4a is a simplified block diagram of an exemplary electronic device according to an example;
FIG. 4b is a simplified block diagram of an exemplary electronic device including an FEM including a switch.
FIG. 5 illustrates an example of a structure of a front-end module (FEM) in an electronic device according to an example;
FIG. 6 illustrates an example of a structure of another FEM in an electronic device according to an example;
FIGS. 7 and 8 illustrate an example of a connection relationship between a power amplified (PA) of one FEM and terminals of one FEM in an electronic device according to an example; and
FIG. 9 illustrates an example of arrangement of antenna modules electrically connected to FEMs in an electronic device according to an example.
FIG. 10 is a simplified block diagram of an exemplary electronic device including a PA disposed outside of a FEM according to an example.
FIG. 11 is a simplified block diagram of an exemplary electronic device including an additional FEM.
FIG. 12 illustrates an example of operation of a switch in an FEM inside an electronic device according to an example.

### [Mode for Invention]

The terms used in the disclosure are merely used to better describe a certain embodiment, and may not be intended to limit the scope of other embodiments. A singular expression may include a plural expression, unless the context clearly dictates otherwise. The terms used herein, including technical and scientific terms, may have the same meanings as those commonly understood by those skilled in the art to which the disclosure pertains. Terms defined in a general dictionary amongst the terms used in the disclosure may be interpreted as having the same as or similar meaning as those in the context of the related art, and they are not to be construed in an ideal or overly formal sense, unless explicitly defined in the disclosure. In some cases, even the terms defined in the disclosure may not be interpreted to exclude embodiments of the disclosure.

In an example of the disclosure described below, a hardware approach will be described as an example. However, since an example of the present disclosure includes a technology that utilizes both the hardware-based and software-based approaches, such an example of the disclosure is not intended to exclude a software-based approach.

Through the following disclosure, terms related to multiple connectivity (e.g., dual connectivity (DC), MR (multi-RAT (radio technology)-DC, cell group, master cell group (MCG), secondary cell group (SCG)), terms referring to signals (e.g., reference signal, system information, control signal, message, data), terms referring to network entities (e.g., communication node, radio node, radio unit, network node, master node (MN), secondary node (SN), transmission/reception point (TRP), a digital unit (DU), radio unit (RU), massive MIMO unit (MMU), and the like are only exemplified for convenience of description. Therefore, the disclosure is not limited to terms to be described below, and any other terms having equivalent technical meanings may be used therefor.

Further, throughout the disclosure, an expression such as e.g., 'exceeding' or 'below' may be used to determine whether a specific condition is satisfied or fulfilled, but it is only of a description for expressing an example and does not exclude the meaning of 'more than or equal to' or 'less than or equal to'. A condition described as 'more than or equal to' may be replaced with 'exceeding' or 'above', a condition described as 'less than or equal to' may be replaced with 'below', and a condition described as 'more than or equal to' and 'below' may be replaced with 'exceeding' and 'less than or equal to', respectively.

The terms used in the disclosure are merely used to better describe a certain embodiment, and may not be intended to limit the scope of other embodiments. A singular expression may include a plural expression, unless the context clearly dictates otherwise. The terms used herein, including technical and scientific terms, may have the same meanings as those commonly understood by those skilled in the art to which the disclosure pertains. Terms defined in a general dictionary amongst the terms used in the disclosure may be interpreted as having the same as or similar meaning as those in the context of the related art, and they are not to be construed in an ideal or overly formal sense, unless explicitly defined in the disclosure. In some cases, even the terms defined in the disclosure may not be interpreted to exclude embodiments of the disclosure.

In an example of the disclosure described below, a hardware approach will be described as an example. However, since an example of the present disclosure includes a technology that utilizes both the hardware-based and software-based approaches, such an example of the disclosure is not intended to exclude a software-based approach.

Through the following disclosure, terms related to multiple connectivity (e.g., dual connectivity (DC), MR (multi-RAT (radio technology)-DC, cell group, master cell group (MCG), secondary cell group (SCG)), terms referring to signals (e.g., reference signal, system information, control signal, message, data), terms referring to network entities (e.g., communication node, radio node, radio unit, network node, master node (MN), secondary node (SN), transmission/reception point (TRP), a digital unit (DU), radio unit (RU), massive MIMO unit (MMU), and the like are only exemplified for convenience of description. Therefore, the disclosure is not limited to terms to be described below, and any other terms having equivalent technical meanings may be used therefor.

Further, throughout the disclosure, an expression such as e.g., 'exceeding' or 'below' may be used to determine whether a specific condition is satisfied or fulfilled, but it is only of a description for expressing an example and does not exclude the meaning of 'more than or equal to' or 'less than or equal to'. A condition described as 'more than or equal to' may be replaced with 'exceeding' or 'above', a condition described as 'less than or equal to' may be replaced with 'below', and a condition described as 'more than or equal to' and 'below' may be replaced with 'exceeding' and 'less than or equal to', respectively.

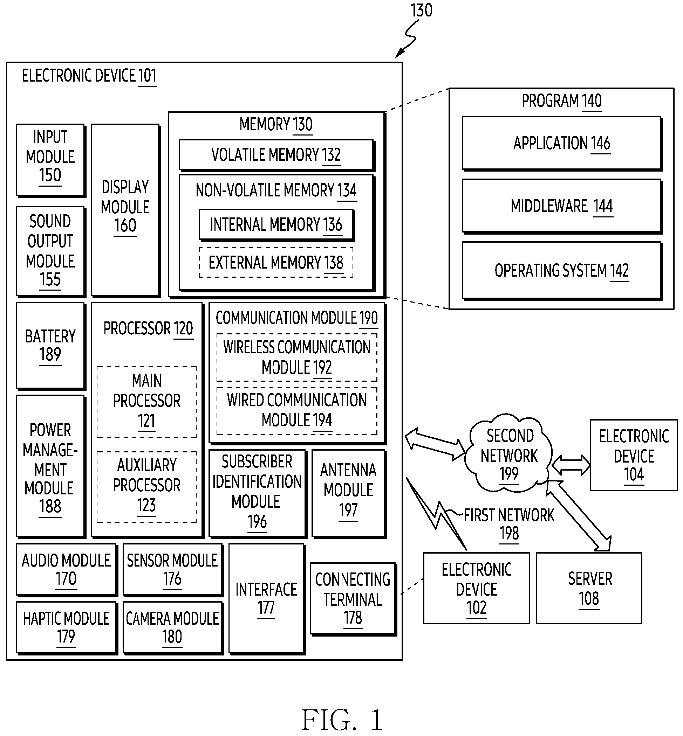

FIG. 1 is a block diagram of an electronic device in a network environment according to an example of the disclosure.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an example, the electronic device 101 may communicate with the electronic device 104 via the server 108. According to an example, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an example, as at least part of the data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an example, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an example, the auxiliary processor 123 (e.g., an image signal processor or a communication processor) may be implemented as part of another component (e.g., the camera module 180 or the communication module 190) functionally related to the auxiliary processor 123. According to an example, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an example, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an example, the display module 160 may include a touch sensor adapted to detect a touch, or a pressure sensor adapted to measure the intensity of force incurred by the touch.

The audio module 170 may convert a sound into an electrical signal and vice versa. According to an example, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an example, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an example, the interface 177 may include, for example, a high-definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an example, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an example, the haptic module 179 may include, for example, a motor, a piezoelectric element, or an electric stimulator.

The camera module 180 may capture a still image or moving images. According to an example, the camera module 180 may include one or more lenses, image sensors, image signal processors, or flashes.

The power management module 188 may manage power supplied to the electronic device 101. According to an example, the power management module 188 may be implemented as at least part of, for example, a power management integrated circuit (PMIC).

The battery 189 may supply power to at least one component of the electronic device 101. According to an example, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an example, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mm Wave band) to address, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an example, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an example, the antenna module 197 may include an antenna including a radiating element including a conductive material or a conductive pattern formed in or on a substrate (e.g., a printed circuit board (PCB)). According to an example, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an example, another component (e.g., a radio frequency integrated circuit (RFIC)) other than the radiating element may be additionally formed as part of the antenna module 197.

According to various embodiments, the antenna module 197 may form a mmWave antenna module. According to an example, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an example, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an example, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another example of the disclosure, the external electronic device 104 may include an internet-of-things (IoT) device. The server 108 may be an intelligent server using machine learning and/or a neural network. According to an example, the external electronic device 104 or the server 108 may be included in the second network 199. The electronic device 101 may be applied to intelligent services (e.g., smart home, smart city, smart car, or healthcare) based on 5G communication technology or IoT-related technology.

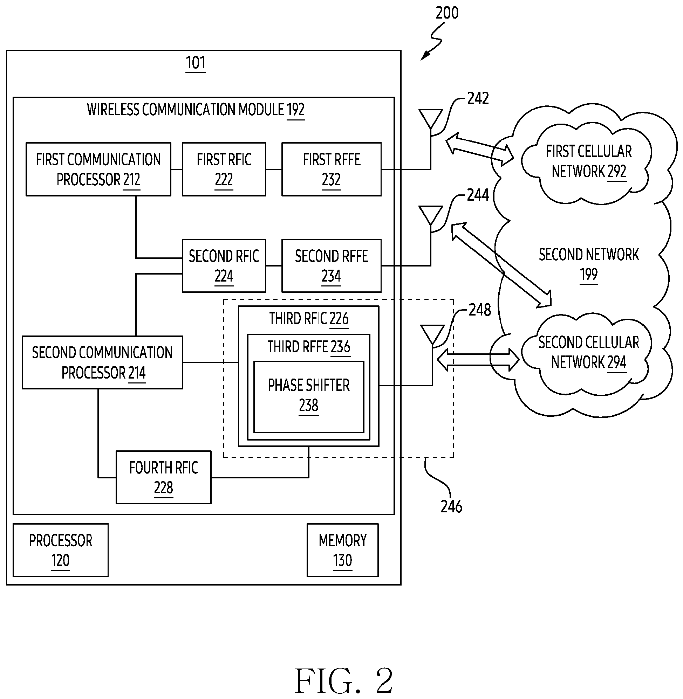

FIG. 2 illustrates an electronic device 101 for supporting legacy network communication and 5G network communication according to an example.

Referring to FIG. 2, the electronic device 101 may further include a first communication processor 212, a second communication processor 214, a first RFIC 222, a second RFIC 224, a third RFIC 226, a fourth RFIC 228, a first radio frequency front end (RFFE) 232, a second RFFE 234, a first antenna module 242, a second antenna module 244, and an antenna 248. The electronic device 101 may further include a processor 120 and a memory 130. The second network 199 may include a first network 292 and a second network 294. According to another example, the electronic device 101 may further include at least one of the components shown in FIG. 1, and the network 199 may further include at least another network. According to an example, the first communication processor 212, the second communication processor 214, the first RFIC 222, the second RFIC 224, the fourth RFIC 228, the first RFFE 232, and the second RFFE 234 may constitute at least a part of the wireless communication module 192. According to another example, the fourth RFIC 228 may be omitted, or may be included as a part of the third RFIC 226.

The first communication processor 212 may establish a communication channel in a band to be used for wireless communication with a first network 292, and may support legacy network communication through the established communication channel. According to an example, the first network may be a legacy network including a second generation (2G), a third generation (3G), a fourth generation (4G), or a long-term evolution (LTE) network. The second communication processor 214 may establish a communication channel corresponding to a designated band (e.g., from about 6 GHz to about 60 GHz) among bands to be used for wireless communication with a second network 294, and may support 5G network communication through the established communication channel. According to an example, the second network 294 may be a 5G network defined in the third-generation partnership project (3GPP). Additionally, according to an example, the first communication processor 212 or the second communication processor 214 may establish a communication channel corresponding to another designated band (e.g., about 6 GHz or less) among bands to be used for wireless communication with the second network 294, and may support 5G network communication through the established communication channel. According to an example, the first communication processor 212 and the second communication processor 214 may be implemented in a single chip or a single package. According to an example, the first communication processor 212 and the second communication processor 214 may be formed in a single chip or a single package with the processor 120, the auxiliary processor 123, or the communication module 190.

At the time of signal transmission, the first RFIC 222 may convert a baseband signal generated by the first communication processor 212 into a radio frequency (RF) signal of about 700 megahertz (MHz) to about 3 GHz used for the first network 292 (e.g., a legacy network). At the time of signal reception, the RF signal may be acquired from the first network 292 (e.g., a legacy network) through an antenna (e.g., the first antenna module 242), and may be preprocessed through RFFE (e.g., the first RFFE 232). The first RFIC 222 may convert the preprocessed RF signal into a baseband signal which can be processed by the first communication processor 212.

At the time of signal transmission, the second RFIC 224 may convert a baseband signal generated by the first communication processor 212 or the second communication processor 214 into an RF signal (hereinafter, a 5G Sub6 RF signal) of a Sub6 band (e.g., about 6 GHz or less) used for the second network 294 (e.g., a 5G network). At the time of signal reception, the 5G Sub6 RF signal may be acquired from the second network 294 (e.g., a 5G network) through an antenna (e.g., the second antenna module 244), and may be preprocessed through RFFE (e.g., the second RFFE 234). The second RFIC 224 may convert the preprocessed 5G Sub6 RF signal into a baseband signal which can be processed by a corresponding communication processor among the first communication processor 212 and the second communication processor 214.

The third RFIC 226 may convert a baseband signal generated by the second communication processor 214 into an RF signal (hereinafter, a 5G Above6 RF signal) of a 5G Above6 band (e.g., from about 6 GHz to about 60 GHz) to be used in the second network 294 (e.g., a 5G network). At the time of signal reception, the 5G Above6 RF signal may be acquired from the second network 294 (e.g., a 5G network) through an antenna (e.g., the antenna 248), and may be preprocessed through the third RFFE 236. The third RFIC 226 may convert the preprocessed 5G Above6 RF signal into a baseband signal that can be processed by the second communication processor 214. According to an example, the third RFFE 236 may be configured as a part of the third RFIC 226.

According to an example, the electronic device 101 may include the fourth RFIC 228 separately from the third RFIC 226 or as at least a part thereof. In this instance, the fourth RFIC 228 may convert a baseband signal generated by the second communication processor 214 into an RF signal (hereinafter, an intermediate-frequency (IF) signal) of an intermediate frequency band (e.g., from about 9 GHz to about 11 GHz) and may then transmit the IF signal to the third RFIC 226. The third RFIC 226 may convert the IF signal into a 5G Above6 RF signal. At the time of signal reception, the 5G Above6 RF signal may be received from the second network 294 (e.g., a 5G network) through an antenna (e.g., the antenna 248) and may be converted into an IF signal by the third RFIC 226. The fourth RFIC 228 may convert the IF signal into a baseband signal that can be processed by the second communication processor 214.

According to an example, the first RFIC 222 and second RFIC 224 may be implemented as at least a part of a single package or a single chip. According to an example, the first RFFE 232 and the second RFFE 234 may be implemented as at least a part of a single package or a single chip. According to an example, at least one antenna module of the first antenna module 242 or the second antenna module 244 may be omitted, or may be combined with the other antenna module to process RF signals of multiple bands corresponding thereto.

According to an example, the third RFIC 226 and antenna 248 may be arranged on the same substrate to constitute a third antenna module 246. For example, the wireless communication module 192 or the processor 120 may be arranged on a first substrate (e.g., a main PCB). In this instance, the third antenna module 246 may be configured by arranging the third RFIC 226 in a partial area (e.g., a lower surface) of a second substrate (e.g., a sub PCB) independent of the first substrate and arranging the antenna 248 in another partial area (e.g., an upper surface) thereof. According to an example, the antenna 248 may include, for example, an antenna array that can be used for beamforming. Arranging the third RFIC 226 and the antenna 248 on the same substrate can reduce the length of a transmission line therebetween, and may reduce the loss (e.g., attenuation) of a signal in a high-frequency band (e.g., about 6GH to about 60 GHz), used for 5G network communication, by a transmission line. Therefore, the electronic device 101 may exhibit an enhanced quality or speed of communication with the second network 294 (e.g., a 5G network).

The second network 294 (e.g., a 5G network) may be operated independently of the first network 292 (e.g., a legacy network) (e.g., stand-alone (SA)) or may be operated while being connected to the first network (e.g., non-stand-alone (NSA)). For example, the 5G network may include only an access network (e.g., a 5G radio access network (RAN) or next-generation RAN (NG RAN)) and may not include a core network (e.g., a next-generation core (NGC)). In this instance, the electronic device 101 may access an access network of a 5G network and may then access an external network (e.g., Internet) under the control of a core network (e.g., an evolved packed core (EPC) network) of a legacy network. Protocol information (e.g., LTE protocol information) for communication with the legacy network or protocol information (e.g., new radio (NR) protocol information) for communication with the 5G network may be stored in a memory 230, and may be accessed by another component (e.g., the processor 120, the first communication processor 212, or the second communication processor 214).

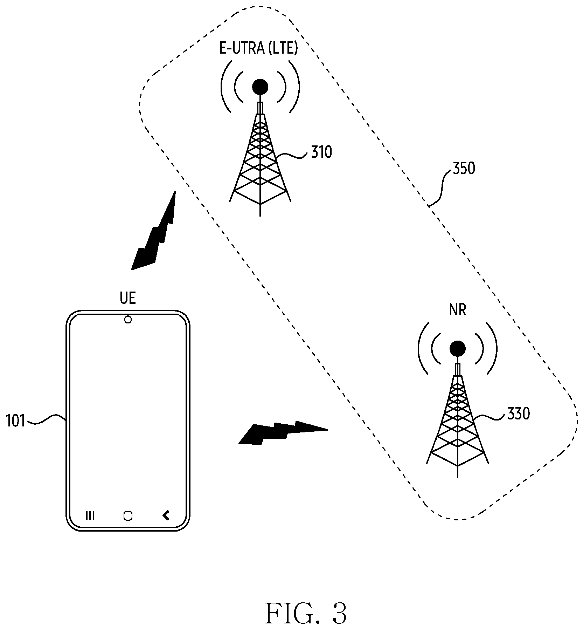

FIG. 3 is a diagram illustrating a wireless communication system for providing a network of legacy communication and/or 5G communication according to an example. FIG. 3 illustrates a first base station 310, a second base station 330, and an electronic device 101 as some of nodes using wireless channels in the wireless communication system.

Referring to FIG. 3, each of the first base station 310 and the second base station 330 may be a network infrastructure that provides radio access to the electronic device 101. Each of the first base station 310 and the second base station 330 may have certain coverage, which corresponds to a geographical area defined based on a distance capable of transmission of radio signals. As used in the following description, the term 'coverage' may refer to a service coverage area in which a service of a base station is available. Each base station may cover a single cell or multiple cells, wherein the multiple cells may be distinguished by a frequency supported by a corresponding base station or an area of a sector covered by that base station.

The first base station 310 may be referred to, in addition to a base station, as an 'access point (AP)', an 'eNodeB (eNB)', a 'wireless point', a 'transmission/reception point (TRP)', a 'distributed unit (DU)', a 'radio unit (RU)', a 'remote radio head (RRH)', or other terms having the technical meaning equivalent thereto. According to an example, the first base station 310 may provide a first communication scheme (e.g., LTE) for a radio access technology (RAT). According to an example, the first base station 310 may operate as an eNB for supporting an evolved universal terrestrial radio access (E-UTRA) carrier in EN-DC. In an example, the electronic device 101 may transmit and receive a radio signal to and from the first base station 310 in a frequency band of about 800 MHz (megahertz) to about 2.6 GHz.

The second base station 330 may be referred to, in addition to a base station, as a '5th generation (5G) node', a '5G node B (NB)', a 'next generation node B (gNB)', a 'wireless point', a 'transmission/reception point (TRP)', a central unit (CU)', a 'distributed unit (DU)', a 'radio unit (RU)', a remote radio head equipment (RRH) or other terms having the technical meaning equivalent thereto. According to an example, the second base station 330 may be connected to one or more 'transmission/reception points (TRPs)'. The second base station 330 may transmit a downlink signal to the electronic device 101 or may receive an uplink signal from the electronic device 101, through the one or more TRPs. According to an example, the second base station 330 may provide a second communication scheme (e.g., NR) for a radio access technology (RAT). According to an example, the second base station 330 may operate as a gNB for supporting NR carriers in EN-DC. In an example, the electronic device 101 may transmit and receive a radio signal in a frequency band of a first frequency range (e.g., NR FR1 of about 410 MHz to about 7125 MHz) or a second frequency range (e.g., NR FR2 of about 24,250 MHz to about 52,600 MHz, or about 24,250 MHz to about 100,000 MHz).

Although not illustrated in FIG. 3, in order to support network function virtualization or more efficient resource management and scheduling in a 5G system, the base station may be implemented in distributed deployment. For example, in a 5G system, a base station (gNB) may be further divided into a central unit (CU) and a distributed unit (DU). For example, the CU may have protocol layers of at least a radio resource control (RRC) and a packet data convergence protocol (PDCP). According to an example, the CU may further include a service data adaptation protocol (SDAP). For example, the DU may have a radio link control (RLC), a medium access control (MAC), and a physical layer. For example, an F1 interface, which is a standardized common interface, may exist between the CU and the DU. The F1 interface may be divided into a control plane F1-C and a user plane F1-U. A transmission network layer of F1-C may be based on IP transmission. For more stable signaling, a stream control transmission protocol (SCTP) may be added over Internet protocol (IP). An application layer protocol may be F1AP. The SCTP may provide stable application layer messaging. A transmission layer of F1-U may be a user datagram protocol (UDP)/IP. A GTP (general packet radio service (GPRS) tunnelling protocol)-U may be used over a UDP/IP to perform user plane protocol data unit PDUs.

The electronic device 101, which is a device used by a user, may communicate with the first base station 310 and/or the second base station 330 through a wireless channel. In some cases, the electronic device 101 may be operated without any user involvement. That is, at least one of the electronic devices 101 is a device that performs machine-type communication (MTC) and may not be carried by a user. The electronic device 101 may referred to, in addition to a terminal, as 'user equipment (UE)', 'mobile station', 'subscriber station', 'customer premises equipment (CPE)', 'remote terminal', 'wireless terminal', 'electronic device', or 'vehicle terminal', 'user device' or other terms having the technical meaning the same as or equivalent thereto.

According to an example, the electronic device 101 may be connected to the first base station 310 and the second base station 330 through dual connectivity (DC) 350. One base station of the first base station 310 and the second base station 330 may operate as a master node (MN), and the other base station of the first base station 310 and the second base station 330 may operate as a secondary node (SN). The MN and SN may be connected to each other through a network interface (e.g., X2 interface or XN interface).

Although not illustrated in FIG. 3, the first base station 310 or the second base station 330 may be connected to an evolved packet core (EPC) network, which is a core of a 4G network. In case where the first base station 310 provides a primary cell group and the second base station 330 provides a secondary cell group, a connection between the two base stations may be referred to as evolved universal terrestrial radio access-new radio dual-connectivity (EN-DC). Through such EN-DC, a terminal may make access to an LTE cell using LTE technology and may make access to an NR cell using NR technology. Hereinafter, a cell using the LTE technology may be referred to as an LTE cell, an E-UTRA cell, or a 4G cell, and a frequency of the cell using the LTE technology may be referred to as an E-UTRA carrier, an LTE carrier, or a 4G carrier. Further, the cell using the NR technology may be referred to as an NR cell or a 5G cell, and a frequency of the cell using the NR technology may be referred to as an NR carrier or a 5G carrier.

Hereinafter, in various embodiments of the present disclosure, EN-DC is described as an example for a technology for providing both the LTE carrier and the NR carrier, but embodiments of the present disclosure are not limited thereto. The same principle of the embodiments described below may be also applied to other types of DCs (e.g., NE-DC (new radio-Evolved universal terrestrial radio access dual-connectivity), NGEN-DC (NG-RAN(next generation-radio access network) evolved universal terrestrial radio access-new radio dual-connectivity)).

Definition of possible types of DCs may be provided as follows.'

**<Table 1>**

| | |
|---|---|
| EN-DC | A dual connection in which an eNB is connected to an evolved packet core (EPC) and a terminal is connected to an eNB acting as an MN and a gNB acting as an SN. Here, the gNB may be referred to as an en-gNB, and the en-gNB may or may not be connected to the EPC. |
| NGEN-DC | A dual connection in which an eNB is connected to a 5G core (5GC) and a terminal is connected to an eNB acting as an MN and a gNB acting as an SN. Here, the eNB may be referred to as an ng-eNB. |
| NE-DC | A dual connection in which a gNB is connected to 5GC and a terminal is connected to a gNB operating as an MN and an eNB operating as an SN. Here, the eNB may be referred to as an ng-eNB. |
| NR-DC: | A dual connectivity in which gNBs are connected to 5GC and a terminal is connected to a gNB acting as an MN and a gNB acting as an SN. NR-DC may also be used when the UE is connected to a single gNB to perform the role of both the MN and the SN and configure both the MCG and the SCG. |

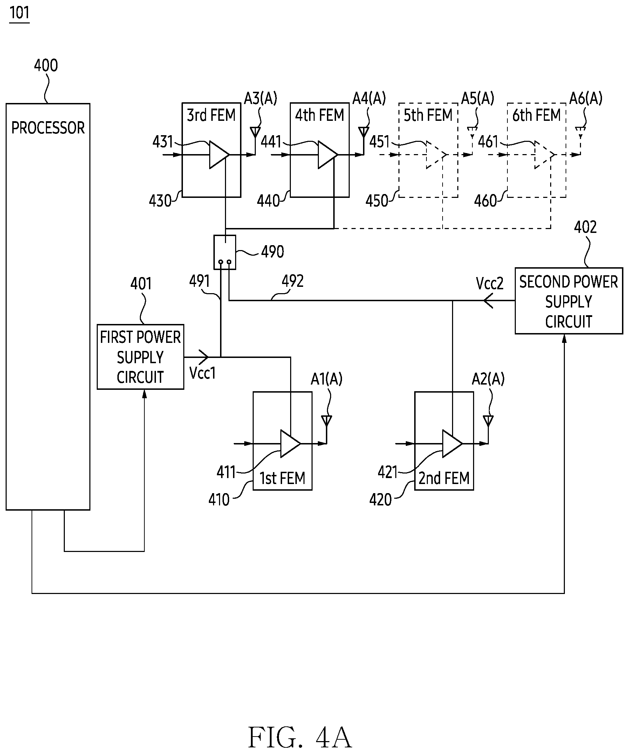

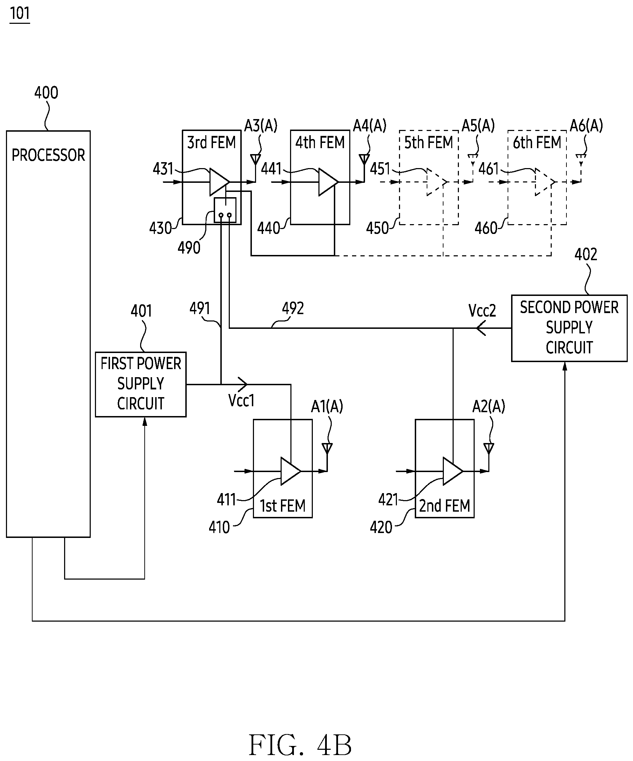

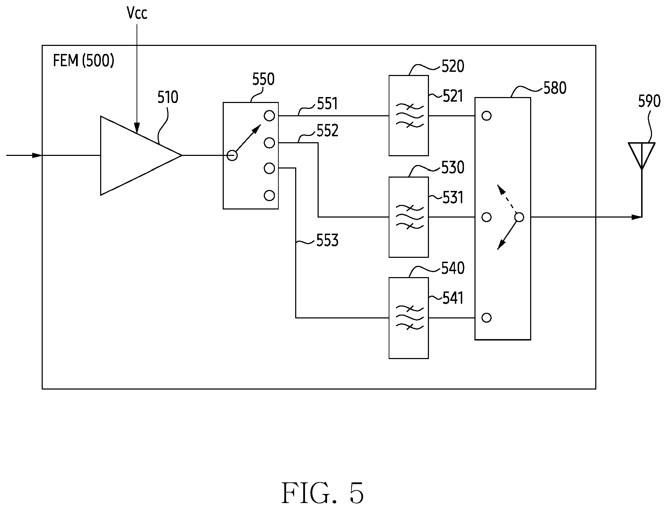

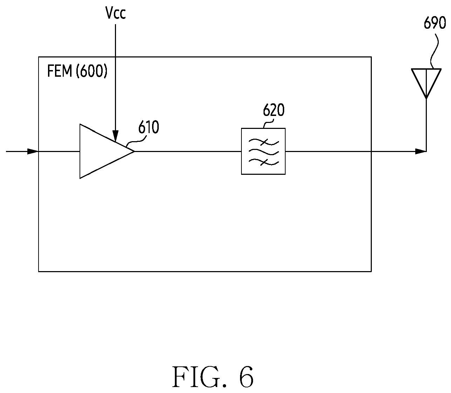

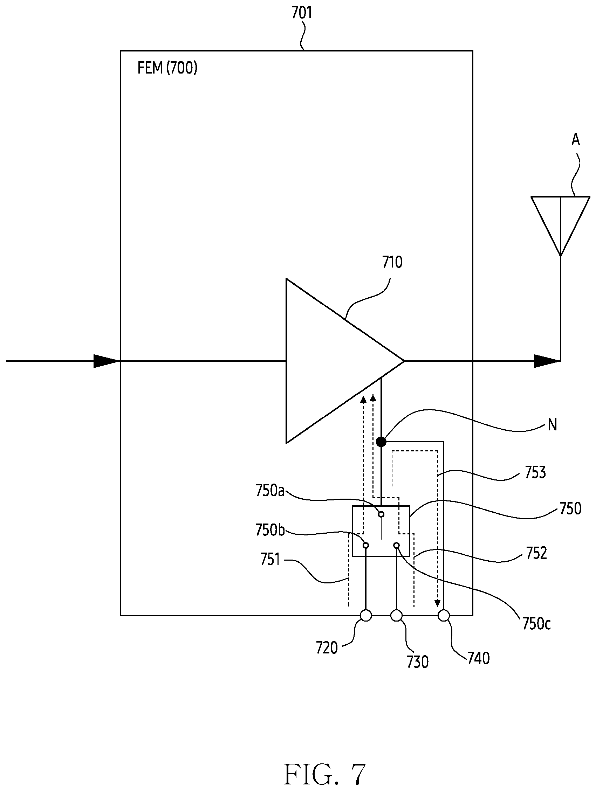

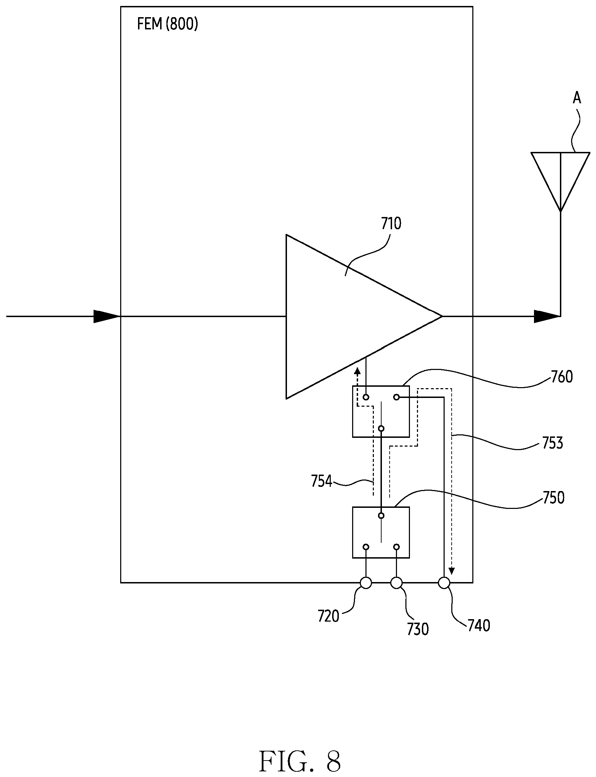

The electronic device 101 may support multi-radio (MR)-DC. The electronic device 101 may be connected to the first base station 310 and the second base station 330. The first base station 310 may be an MN, and the second base station 330 may be an SN, so that they may be connected to the terminal. Along with carrier aggregation (CA) provided by each base station, the dual connection may provide a higher data rate. The first base station 310 and the second base station 330 may transmit downlink traffic to the electronic device 101 or receive uplink traffic from the electronic device 101, as an MN and an SN, respectively FIG. 4a is a simplified block diagram of an exemplary electronic device according to an example. FIG. 4b is a simplified block diagram of an exemplary electronic device including an FEM including a switch. FIG. 5 illustrates an example of a structure of a front-end module (FEM) in an electronic device according to an example. FIG. 6 illustrates an example of a structure of another FEM in an electronic device according to an example. And FIGS. 7 and 8 each illustrate an example of a connection relationship between a power amplified (PA) of one FEM and terminals of one FEM in an electronic device according to an example.

Referring to FIGS. 4a, 4b, 5, 6, 7 and 8, the electronic device 101 may include a processor 400, a first power supply circuit 401, a second power supply circuit 402, a first FEM 410, a second FEM 420, a third FEM 430, a fourth FEM 440, a fifth FEM 450, and/or a sixth FEM 460.

In an example, the processor 400 may include the processor 120 illustrated in FIG. 1. In an example, the processor 400 may include at least one of the processor 120, the first communication processor 212, the second communication processor 214, the first RFIC 222, the second RFIC 224, the third RFIC 226, the fourth RFIC 228, as illustrated in FIG. 2 or transceiver.

The FEMs 410, 420, 430, 440, 450, and 460 in the electronic device 101 may include components for processing a signal transmitted through at least one of antennas A1, A2, A3, A4, A5, and A6 respectively connected to the FEMs 410, 420, 430, 440, 450, and 460. Each of the FEMs 410, 420, 430, 440, 450, and 460 may be connected to one of the antennas A1, A2, A3, A4, A5, and A6. According to an example, some of the antennas A1, A2, A3, A4, A5, and A6 may be connected to one or more FEMs. For example, each of the FEMs 410, 420, 430, 440, 450, and 460 may include at least one filter (e.g., a first filter 521, a second filter 531, or a third filter 541) for processing the signal transmitted through one of the antennas A1, A2, A3, A4, A5, and A6, at least one power amplifier (PA) (e.g., a first PA 411, a second PA 421, a third PA 431, a fourth PA 441, a fifth PA 451, and/or a sixth PA 461), a switch (e.g., a switch 550 and/or a switch 580), or a duplexer (e.g., a first duplexer 520, a second duplexer 530, or a third duplexer 540). Each of the FEMs 410, 420, 430, 440, 450, and 460 may be configured to process signals having different frequencies. For example, a first frequency band of a first signal processed by the first FEM 410 and transmitted through the antenna A (e.g., at least one of the antennas A1, A2, A3, A4, A5, and A6) may be spaced apart from a second frequency band of a second signal processed by the second FEM 420 and transmitted through the antenna. The first frequency band of the first signal processed by the first FEM 410 and transmitted through the antenna may partially overlap a third frequency band of a third signal processed by the third FEM 430 and transmitted through the antenna. However, the disclosure is not limited thereto. A voltage for the operating range of the PAs 411, 421, 431, 441, 451, and 461 may be set by the processor 400. According to an example, the voltage may be set by at least one radio frequency integrated circuit (RFIC) (not shown) connected to the processor 400 and each FEM. Meanwhile, the FEM may be referred to as a radio frequency chain or an RF path.

The antenna A (e.g., at least one of the antennas A1, A2, A3, A4, A5, and A6) may include at least a portion of the antenna module illustrated in FIG. 1. For example, the antenna A may include at least one array antenna including multiple antennas. According to an example, the antenna A may include an antenna that uses a conductive portion arranged along at least part of a side surface of a housing of the electronic device 101. According to an example, the antenna A may include a plurality of antennas, and the plurality of antennas may correspond to each FEM. However, the disclosure is not limited thereto, and the number of a plurality of antennas may be different from the number of FEMs. For example, the third FEM 430 and the fourth FEM 440 may be connected to one antenna, and the one antenna connected to the third FEM 430 and the fourth FEM 440 may be an antenna shared for the third FEM 430 and the fourth FEM 440. The fifth FEM 450 and the sixth FEM 460 may be connected to another antenna, and the other antenna connected to the fifth FEM 450 and the sixth FEM 460 may be an antenna shared for the fifth FEM 450 and the sixth FEM 460. According to an example, although it has been described that six FEMs are disposed, the disclosure is not limited thereto and the FEMs may include less than six FEMs or more than six FEMs. For example, the plurality of FEMs may include a first FEM 410, a second FEM 420, a third FEM 430, and/or a fourth FEM 440. The FEMs may be configured to transmit different RF signals to the outside. For example, the first FEM 410 may include a first PA 411 configured to transmit a first RF signal of a first frequency. The first PA 411 may be configured to amplify the first RF signal based on the voltage Vcc1 of the first power supply circuit 401. The second FEM 420 may include a second PA 421 configured to transmit a second RF signal of a second frequency, distinct from the first RF signal. The second PA 421 may be configured to amplify the second RF signal based on the voltage Vcc2 of the second power supply circuit 402. The third FEM 430 may include a third PA 431 configured to transmit a third RF signal of a third frequency, distinct from the first RF signal and the second RF signal. The third PA 431 may be configured to amplify the third RF signal based on the voltage Vcc1 of the first power supply circuit 401 or the voltage Vcc2 of the second power supply circuit 402. The fourth FEM 440 may include a fourth PA 441 configured to transmit a fourth RF signal of a fourth frequency, distinct from the first RF signal, the second RF signal, and the third RF signal. The fourth PA 441 may be configured to amplify the fourth RF signal based on the voltage Vcc1 of the first power supply circuit 401 or the voltage Vcc2 of the second power supply circuit 402. The fifth FEM 450 may include a fifth PA 451 configured to transmit a fifth RF signal of a fifth frequency, distinct from the first RF signal, the second RF signal, the third RF signal, and the fourth RF signal. The fifth PA 451 may be configured to amplify the fifth RF signal based on the voltage Vcc1 of the first power supply circuit 401 or the voltage Vcc2 of the second power supply circuit 402. The sixth FEM 460 may include a sixth PA 461 configured to transmit a sixth RF signal of a sixth frequency, distinct from the first RF signal, the second RF signal, the third RF signal, the fourth RF signal, and the fifth RF signal. The sixth PA 461 may be configured to amplify the sixth RF signal based on the voltage Vcc1 of the first power supply circuit 401 or the voltage Vcc2 of the second power supply circuit 402. The third PA 431, the fourth PA 441, the fifth PA 451, and/or the sixth PA 461 may be connected to the switch 490.

The switch 490 of FIG. 4a may be located outside the FEM 460. The switch 490 may be supply the voltage Vcc1 of the first power supply circuit 401 and/or the voltage Vcc2 of the second power supply circuit 402 to the third PA 431, the fourth PA 441, the fifth PA 451, and/or the sixth PA 461 through a connection with the third PA 431, the fourth PA 441, the fifth PA 451, and/or the sixth PA 461. The switch 490 of FIG. 4b may be disposed inside one FEM among the third FEM 430, the fourth FEM 440, the fifth FEM 450, and/or the sixth FEM 460. For example, the third FEM 430may include the switch 490. At least one power supply circuit (e.g., the first power supply circuit 401 or the second power supply circuit 402) may variably supply the voltage to the Pas, based on control of the processor 400 and/or a radio frequency integrated circuit (RFIC) (not shown). According to an example, the voltage for the dynamic operating range of the PAs 411, 421, 431, 441, 451, and 461 may be set by the processor 400. The voltage may be also set by the radio frequency integrated circuit (RFIC) (not shown) connected to the processor 400 and each of the FEMs 410, 420, 430, 440, 450, and 460. For example, the RFIC may set the voltage through one or more power supply circuits 401 and 402, based on envelope tracking (ET). However, the disclosure is not limited thereto. The at least one power supply circuit 401 or 402 may variably supply the voltage to the PAs 411, 421, 431, 441, 451, and 461 based on the control of the processor 400 and/or the RFIC. For example, the at least one power supply circuit 401 or 402 may be used to set the voltage based on the ET. According to an example, the at least one power supply circuit 401 or 402 may be used to set the voltage based on average power tracking (APT). At least one of the power supply circuits 401 and 402 is described as supplying voltage, but may supply power to the PAs 411, 421, 431, 441, 451 and 461. The at least one power supply circuit 401 or 402 may be referred to as a modulator, an ET modulator, a supply modulator, a power supply, a power supplier or a voltage supply circuit.

According to an example, the at least one power supply circuit may include the first power supply circuit 401 and/or the second power supply circuit 402. For example, each of the PAs 431, 441, 451, and 461 included in each of some FEMs 430, 440, 450, and 460 amongst the FEMs may receive the voltage or the power from the first power supply circuit 401 or the second power supply circuit 402. For example, the first PA 411 included in the first FEM 410 amongst the FEMs may receive the first voltage Vcc1 or a power from the first power supply circuit 401. For example, the second PA 421 included in the second FEM 420 amongst the FEMs may receive the second voltage Vcc2 or a power from the second power supply circuit 402. For example, the first power supply circuit 401 may be configured to supply the first voltage Vcc1 to the PAs 411, 431, 441, 451, and 461 included in each of the first FEM 410, the third FEM 430, the fourth FEM 440, the fifth FEM 450, and the sixth FEM 460. According to an example, the first voltage Vcc1 transmitted from the first power supply circuit 401 to the PAs 411, 431, 441, 451, and 461 may not be the same. For example, by the voltage drop, the voltage applied to the third PA 431, the fourth PA 441, the fifth PA 451 or the sixth PA 461 from the first power supply circuit 401 through the switch or the third FEM 430 may be lower than the voltage applied to the third PA 431 from the first power supply circuit 401. For example, the second power supply circuit 402 may be configured to supply the second voltage Vcc2 to the PAs 421, 431, 441, 451, and 461 included in each of the second FEM 420, the third FEM 430, the fourth FEM 440, the fifth FEM 450, and the sixth FEM 460. According to an example, the second voltage Vcc2 transmitted from the second power supply circuit 402 to the PAs 411, 431, 441, 451, and 461 may not be the same. For example, by the voltage drop, the voltage applied to the third PA 431, the fourth PA 441, the fifth PA 451 or the sixth PA 461 from the second power supply circuit 402 through the switch or the third FEM 430 may be lower than the voltage applied to the third PA 431 from the second power supply circuit 402. The first PA 411 of the first FEM 410 may receive the first voltage Vcc1 through the first power supply circuit 401. The first PA 411 may receive the power from the first power supply circuit 401. The second PA 421 of the second FEM 420 may receive the second voltage Vcc2 through the second power supply circuit 402. The second PA 412 may receive the power from the second power supply circuit 402. Each of the PAs 431, 441, 451, and 461 of each of the third FEM 430, the fourth FEM 440, the fifth FEM 450, and the sixth FEM 460 may receive the first voltage Vcc1 or the second voltage Vcc2 through the first power supply circuit 401 or the second power supply circuit 402. Each of the Pas 431, 441, 451, and 461 may be receive the power from the first power supply circuit 401 or the power from the second power supply circuit 402.

The processor 400 according to an example may be configured to operate one PA (e.g., the first PA 411) amongst the PAs 411, 431, 441, 451, and 461 in the FEMs 410, 430, 440, 450, and 460 supplied with the first voltage Vcc1 from the first power supply circuit 401, and operate a PA in one FEM amongst the FEMs 420, 430, 440, 450, and 460 supplied with the second voltage Vcc2 from the second power supply circuit 402, being distinct from the PA (e.g., the first PA 411) in one FEM (e.g., the first FEM 410) amongst the FEMs 410, 430, 440, 450, and 460 supplied with the first voltage Vcc1.

According to an example, in order to supply the first voltage Vcc1 supplied from the first power supply circuit 401 and the second voltage Vcc2 supplied from the second power supply circuit 402, to a designated FEM, the switch 490 may be operatively connected to the processor 400. The processor 400 may include at least one of processor 120, the first communication processor 212, the second communication processor 214, the first RFIC 222, the second RFIC 224, the third RFIC 226, the fourth RFIC 228, as illustrated in FIG. 2 or transceiver. The switch 490 may be controlled by the processor 400. The switch 490 may selectively connect the third FEM 430, the fourth FEM 440, the fifth FEM 450, and the sixth FEM 460 to either the first power supply circuit 401 or the second power supply circuit 402. For example, switch 490 may be configured to route one voltage selected from the first voltage Vcc1 (or control signal) output from the first power supply circuit 401 and the second voltage Vcc2 output from the second power supply circuit under the control of the processor, to a signal path for providing to third FEM 430.The first power supply circuit 401 may always be electrically connected to the first FEM 410, and may be selectively connected to the third FEM 430, the fourth FEM 440, the fifth FEM 450, and the sixth FEM 460 through the switch 490 and a path 491 connected to the switch 490. The second power supply circuit 402 may always be electrically connected to the second FEM 420, and may be selectively connected to the third FEM 430, the fourth FEM 440, the fifth FEM 450, and the sixth FEM 460 through the switch 490 and a path 492 connected to the switch 490.

The switch 490 may include a first terminal 490a connected to each of the third PA 431 and the fourth PA 441, a second terminal 490b connected to the first power supply circuit 401, and a third terminal 490c connected to the second power supply circuit 402. While transmitting a signal using the second PA 421, the switch 490 may connect the first terminal 490a to the second terminal 490b to transmit a signal using the third PA 431, the fourth PA 441, the fifth PA 451, and/or the sixth PA 461 operating based on a voltage from the first power supply circuit 401. The second PA 421 may operate based on a voltage from the second power supply circuit 402. While transmitting a signal using the first PA 411, the switch 490 may connect the first terminal 490a to the third terminal 490c to transmit a signal using the third PA 431, the fourth PA 441, the fifth PA 451, and/or the sixth PA 461 operating based on a voltage from the second power supply circuit 402. The switch 490 may be referred to as a routing component in terms of setting one path among several paths.

According to an example, the processor 400 may be configured to provide a first connection state and a second connection state between the power supply circuits 401 and 402 and the PAs 411, 421, 431, 441, 451, and 461, through the switch 490. The first connection state may be a state that electrically connects the second power supply circuit 402 to the third PA 431, the fourth PA 441, the fifth PA 451, and the sixth PA 461 through the switch 490, based on transmitting a signal using the first PA 411 operating based on the first voltage Vcc1 provided from the first power supply circuit 401, in order to transmit a signal using the third PA 431, the fourth PA 441, the fifth PA 451, or the sixth PA 461 operating based on the second voltage Vcc2 provided from the second power supply circuit 402.

In the first connection state, the processor 120 may be configured to control the switch 490 to connect the second power supply circuit 402 to the third PA 431 to transmit a signal using the third PA 431, the fourth PA 441, the fifth PA 451, and/or the sixth PA461. The processor 120 may be configured to provide to the third FEM 430 a control signal that causes the switch 490 to connect the second power supply circuit 402 to the third PA 431 to transmit a signal using the third PA 431, the fourth PA 441, the fifth PA 451, and/or the sixth PA461. The third PA 431 may be connected through the electrical path to the fourth PA 441, the fifth PA 451, and/or the sixth PA461. The third PA 431, the fourth PA 441, the fifth PA 451, and/or the sixth PA 461 operates based on the second voltage Vcc2 provided from the second power supply circuit 402, while transmitting a signal using the first PA 411. The third PA 431, the fourth PA 441, the fifth PA 451, and/or the sixth PA 461 may operate based on the second voltage Vcc2 provided from the second power supply circuit 402, while the first PA obtains the first voltage Vcc1 provided from the first power supply circuit 401 to transmit a signal using the first PA 411.

The second connection state may be a state that electrically connect the first power supply circuit 401 to the third PA 431, the fourth PA 441, the fifth PA 451, and the sixth PA 461 through the switch 490, based on transmitting a signal using the second PA 421 operating based on the second voltage Vcc2 provided from the second power supply circuit 402, in order to transmit a signal using the third PA 431, the fourth PA 441, the fifth PA 451, or the sixth PA 461 operating based on the first voltage Vcc1 provided from the first power supply circuit 401.

In the second connection state, the processor 120 may be configured to control the switch 490 to connect the first power supply circuit 401 to the third PA 431 to transmit a signal using the third PA 431, the fourth PA 441, the fifth PA 451, and/or the sixth PA 461. The processor 120 may be configured to provide to the third FEM 430 a control signal that causes the switch 490 to connect the first power supply circuit 401 to the third PA 431 to transmit a signal using the third PA 431, the fourth PA 441, the fifth PA 451, and/or the sixth PA461. The third PA 431, the fourth PA 441, the fifth PA 451, and/or the sixth PA 461 may operate based on the first voltage Vcc1 provided from the first power supply circuit 401, while transmitting a signal using the second PA 441. The third PA 431, the fourth PA 441, the fifth PA 451, and/or the sixth PA 461 may operate based on the first voltage Vcc1 provided from the first power supply circuit 401, while the second PA 421 may obtain the second voltage Vcc2 provided from the second power supply circuit 402 to transmit a signal using the second PA 421.

The processor 400 may be configured to simultaneously transmit the first RF signal and one selected from among the third RF signal to the sixth RF signal in the first connection state. The processor 400 may be configured to simultaneously transmit the second RF signal and one selected from among the third RF signal to the sixth RF signal in the second connected state.

According to an example, while providing a voltage to one PA through the first power supply circuit 401, the processor 400 may provide a voltage to another PA other than the PA through the second power supply circuit 402.

According to an example, the processor 400 may transmit a signal to an external electronic device using the first PA 411 and transmit a signal to another external electronic device distinct from the external electronic device using one of the second PA 421, the third PA 431, the fourth PA 441, the fifth PA 451, or the sixth PA 461. However, the disclosure is not limited thereto, and the processor 400 may transmit a signal to an external electronic device using the first PA 411, and transmit a signal to another external electronic device distinct from the external electronic device, using a plurality of PAs amongst the second PA 421, the third PA 431, the fourth PA 441, the fifth PA 451, or the sixth PA 461. For example, while transmitting a signal through an antenna, using the first PA 411 operating based on the first voltage Vcc1 provided from the first power supply circuit 401, the processor 400 may supply the second voltage Vcc2 provided from the second power supply circuit 402 to the third PA 431, the fourth PA 441, the fifth PA 451, and/or the sixth PA 461 through the switch 490. For example, while transmitting the signal to the outside through the antenna A1 using the first PA 411, the processor 400 may be configured to refrain from causing the switch 490 to electrically connect the first power supply circuit 401 with the third PA 431, the fourth PA 441, the fifth PA 451, and the sixth PA 461, and to cause the switch 490 to electrically connect the second power supply circuit 402 with the third PA 431, the fourth PA 441, the fifth PA 451, and the sixth PA 461. For example, the processor 400 may communicate with an external electronic device through an antenna A3, A4, A5, or A6 connected to one PA amongst the third PA 431, the fourth PA 441, the fifth PA 451, and the sixth PA 461, being supplied with the second voltage Vcc2 from the second power supply circuit 402.

According to an example, the processor 400 may control to deactivate the remaining PAs except for one PA communicating with the external electronic device among the third PA 431, the fourth PA 441, the fifth PA 451, and the sixth PA 461 which are supplied with the second voltage Vcc2. For example, Among Pas 431, 441, 451 and 461 supplied with the voltage through the switch 490, a PA that does not transmit a signal may be disabled, the processor 400 may identify one PA communicating with an external electronic device amongst the third PA 431, the fourth PA 441, the fifth PA 451, and the sixth PA 461. Based on identifying that the one PA is the third PA 431, the processor 400 may transmit a signal for requesting deactivation to the fourth PA 441, the fifth PA 451, and the sixth PA 461.

According to an example, on the basis of the above-described operations, the processor 400 may be configured to, based on transmitting a signal using the first PA 411 operating based on the first voltage Vcc1 provided from the first power supply circuit 401, electrically connect the second power supply circuit 402 with the third PA 431, the fourth PA 441, the fifth PA 451, or the sixth PA 461, through the switch 490, in order to transmit a signal using one PA amongst the third PA 431, the fourth PA 441, the fifth PA 451, or the sixth PA 461 operating based on the second voltage Vcc2 provided from the second power supply circuit 402. As another example, based on transmitting a signal using the second PA 421 operating based on the voltage provided from the second power supply circuit 402, the processor 400 may be configured to electrically connect the first power supply circuit 401 to the third PA 431, the fourth PA 441, the fifth PA 451, or the sixth PA 461, through the switch 490, in order to transmit a signal using one PA amongst the third PA 431, the fourth PA 441, the fifth PA 451, or the sixth PA 461 operating based on the first voltage provided from the first power supply circuit 401.

According to an example, the processor 400 may be configured to receive a control message from the first external electronic device, while a signal is transmitted to the first external electronic device (e.g., the first base station 310 of FIG. 3) using the first PA 411. The control message may be an RRC message. The control message may include information related to a second external electronic device (e.g., the second base station 330 of FIG. 3) requesting an additional connection with the electronic device 101 and/or a frequency band for the connection therewith.

According to an example, the processor 400 may be configured to identify, based on the control message, a PA for a signal to be transmitted while the signal is transmitted using the first PA 411, from among the second PA 421, the third PA 431, the fourth PA 441, the fifth PA 451, and the sixth PA 461. The processor 400, based on the information within the control message, may identify a frequency band of a signal to be transmitted while the signal is transmitted using the first PA 411, and identify an FEM, a PA, and/or an antenna for the signal to be transmitted, based on the frequency band.

According to an example, the processor 400 may be configured to electrically connect the second power supply circuit 402 to the third PA 431, the fourth PA 441, the fifth PA 451, and the sixth PA 461 through the switch 490, on condition that the identified PA is determined as the third PA 431, the fourth PA 441, the fifth PA 451, or the sixth PA 461. For example, when the identified PA is the third PA 431, the processor 400 may be configured to electrically connect the second power supply circuit 402 with the third PA 431, the fourth PA 441, the fifth PA 451, and the sixth PA 461 through the switch 490. The switch 490 may be configured to electrically connect the third PA 431, the fourth PA 441, the fifth PA 451, and the sixth PA 461 to the first power supply circuit 401 or the second power supply circuit 402. When the first power supply circuit 401 is electrically connected to the third PA 431, the fourth PA 441, the fifth PA 451, and the sixth PA 461, the second power supply circuit 402 may be electrically disconnected from the third PA 431, the fourth PA 441, the fifth PA 451, and the sixth PA 461.

According to an example, the signal transmitted using the first PA 411 may be transmitted to the first external electronic device (e.g., the first base station 310 of FIG. 3) according to a first communication scheme (e.g., LTE). The signal transmitted using the PA identified amongst the second PA 421, the third PA 431, the fourth PA 441, the fifth PA 451, and the sixth PA 461 may be transmitted to a second external electronic device (e.g., the second base station 330 of FIG. 3) distinct from the first external electronic device (e.g., the first base station 310 of FIG. 3) according to a second communication scheme (e.g., NR) distinguished from the first communication scheme. For example, based on the control message, the processor 400 may be configured to electrically connect the third PA 431, the fourth PA 441, the fifth PA 451, and/or the sixth PA 461 through the switch 490 with the second power supply circuit 402, based on identifying that a PA for a signal to be transmitted to the second external electronic device according to the second communication scheme is the third PA 431. Based on the control message, the processor 400 may be configured to electrically connect the third PA 431, the fourth PA 441, the fifth PA 451, and/or the sixth PA 461 through the switch 490 with the second power supply circuit 402, based on identifying that the PA for the signal to be transmitted to the second external electronic device according to the second communication scheme is the fourth PA 441. As another example, based on the control message, the processor 400 may be configured to refrain from electrically connecting the third PA 431, the fourth PA 441, the fifth PA 451, and the sixth PA 461 through the switch 490 with the second power supply circuit 402, based on identifying that the PA for the signal to be transmitted to the external electronic device according to the second communication scheme is the second PA 421.

According to an example, the processor 400 may be configured to receive a control message from the first external electronic device while a signal is transmitted to the first external electronic device using the second PA 421, identify, based on the control message, a PA for a signal to be transmitted while the signal is transmitted using the second PA 421, amongst the first PA 411, the third PA 431, the fourth PA 441, the fifth PA 451, and the sixth PA 461, and on condition that the identified PA is identified as the third PA 431, the fourth PA 441, the fifth PA 451, or the sixth PA 461, electrically connect the first power supply circuit 401 to the third PA 431, the fourth PA 441, the fifth PA 451, and the sixth PA 461 through the switch. The signal transmitted using the second PA 421 may be transmitted to the first external electronic device according to the first communication scheme. The signal transmitted using the identified PA amongst the first PA 411, the third PA 431, the fourth PA 441, the fifth PA 451, and the sixth PA 461 may be transmitted to a second external electronic device distinct from the first external electronic device according to the second communication scheme distinguished from the first communication scheme.

According to an example, based on the control message, the processor 400 may electrically connect the third PA 431, the fourth PA 441, the fifth PA 451, and the sixth PA 461 with the first power supply circuit 401 through the switch 490, based on identifying that the PA for the signal to be transmitted to the second external electronic device according to the second communication scheme is the third PA 431. Based on the control message, the processor 400 may electrically connect the first power supply circuit 401 with the third PA 431, the fourth PA 441, the fifth PA 451, and the sixth PA 461 through the switch 490, based on identifying that the PA for the signal to be transmitted to the external electronic device according to the second communication scheme is the fourth PA 441. Based on the control message, the processor 400 may electrically connect the first power supply circuit 401 with the third PA 431, the fourth PA 441, the fifth PA 451, and the sixth PA 461 through the switch 490, based on identifying that the PA for the signal to be transmitted to the first external electronic device according to the second communication scheme is the fifth PA 451. Based on the control message, the processor 400 may electrically connect the first power supply circuit 401 with the third PA 431, the fourth PA 441, the fifth PA 451, and the sixth PA 461 through the switch 490, based on identifying that the PA for the signal to be transmitted to the second external electronic device according to the second communication scheme is the sixth PA 461. Based on the control message, the processor 400 may be configured to refrain from electrically connecting the first power supply circuit 401 with the third PA 431, the fourth PA 441, the fifth PA 451, and the sixth PA 461 through the switch 490, based on identifying that the PA for the signal to be transmitted to the second external electronic device according to the second communication scheme is the first PA 411.

According to an example, the processor 400 may control to refrain from operating the second PA 421, the fourth PA 441, the fifth PA 451, and the sixth PA 461, based on identifying that the PA identified based on the control message is the third PA 431, while providing a voltage to the first PA 411 through the first power supply circuit 401 and transmitting a signal to the external electronic device through the first PA 411. According to an example, the processor 400 may control to refrain from operating the first PA 411, the fourth PA 441, the fifth PA 451, and the sixth PA 461, based on identifying that the PA identified based on the control message is the third PA 431, while providing the second voltage to the second PA 421 through the second power supply circuit 401 and transmitting the signal to the external electronic device through the second PA 421.

Instead of arranging a power switch in each of components (e.g., the third FEM 430, the fourth FEM 440, the fifth FEM 450, and/or the sixth FEM 460), which have to receive power from the first power supply circuit 401 and the second power supply circuit 402 according to the above-described embodiment, the switch 490 may be disposed outside the third FEM 430, the fourth FEM 440, the fifth FEM 450, and/or the sixth FEM 460. The switch 490 disposed out of the third FEM 430, the fourth FEM 440, the fifth FEM 450, and/or the sixth FEM 460 may electrically connect the first power supply circuit 401 to the third FEM 430, the fourth FEM 440, the fifth FEM 450, or the sixth FEM 460, or may electrically connect the second power supply circuit 402 to the third FEM 430, the fourth FEM 440, the fifth FEM 450, and/or the sixth FEM 460. As described above, the switch 490 may secure antenna freedom capable of supporting various frequency bands, through electrical connection in between the third FEM 430, the fourth FEM 440, the fifth FEM 450, and/or the sixth FEM 460 and the first power supply circuit 401 or the second power supply circuit 402.

Referring to FIGS. 5 and 6, the FEM 500 of FIG. 5 may be an FEM for an antenna capable of supporting multiple bands. The FEM 600 of FIG. 6 may be an FEM for an antenna capable of supporting a single band. The FEM 500 may be configured to support multiple bands, including a plurality of filters or a plurality of duplexers. According to an example, the FEM 500 may be an FEM capable of supporting an LTE frequency domain or EN-DC. For example, the FEM 500 may be the first FEM 410, the second FEM 420, the fifth FEM 450, or the sixth FEM 460 illustrated in FIG. 4a or FIG. 4b. According to an example, the FEM 600 may be connected to an antenna supporting an ultra-high band (UHB) of an NR frequency domain. For example, the FEM 600 may be the third FEM 430 or the fourth FEM 440 illustrated in FIG. 4a or FIG. 4b. However, the disclosure is not limited thereto, and the FEM 500 of FIG. 5 and the FEM 600 of FIG. 6 may be implemented in various combinations in the electronic device 101.

Referring to FIG. 5, the FEM 500 may be operatively and/or electrically connected to an antenna 590 (e.g., the antenna A of FIG. 4a or FIG. 4b). In an example, the FEM 500 may include a first duplexer 520 operatively and/or electrically connectable to the antenna 590, a second duplexer 530 operatively and/or electrically connectable to the antenna 590, and/or a third duplexer 540 operatively and/or electrically connectable to the antenna 590.

The first duplexer 520 may include a first filter 521 for passing a first signal in an uplink frequency range of a first frequency band. The uplink frequency range of the first frequency band may be referred to as a transmission frequency range of the first frequency band in terms of a frequency range of a signal transmitted from the electronic device 101.

Similar to the first duplexer 520, the second duplexer 530 may include a second filter 531 for passing a signal in an uplink frequency range of a second frequency band different from the first frequency band. The third duplexer 540 may include a third filter 541 for passing a signal in an uplink frequency range of a third frequency band different from the first frequency band and the second frequency band.

According to an example, the FEM 500 may further include a switch 550. For example, the switch 550 may be controlled by the processor 400. For example, the processor 400 may, through the switch 550, operatively connect the PA 510 and the first filter 521 in the first duplexer 520, operatively connect the PA 510 and the second filter 531 in the second duplexer 530, operatively connect the PA 510 and the third filter 541 in the third duplexer 540, or operatively disconnect the PA 510 from the first filter 521, the second filter 531, and the third filter 541. For example, based on the control of the processor 400, the switch 550 may have a first state of forming (or providing) a first electrical path 551 between the PA 510 and the first filter 521 in the first duplexer 520, a second state of forming a second electrical path 552 connecting the PA 510 and the second filter 531 in the second duplexer 530, a third state of forming a third electrical path 553 connecting the PA 510 and the third filter 541 in the third duplexer 540, or a fourth state of disconnecting all the first electrical path 551, the second electrical path 552, and the third electrical path 553.

According to an example, the FEM 500 may further include a switch 580. For example, the switch 580 may be controlled by the processor 400. For example, the processor 400, through the switch 580, may operatively connect the first duplexer 520 and the antenna 590, operatively connect the second duplexer 530 and the antenna 590, operatively connect the third duplexer 540 and the antenna 590, operatively connect two duplexers of the first duplexer 520, the second duplexer 530 and the third duplexer 540 with the antenna 590, operatively connect all of the first duplexer 520, the second duplexer 530, and the third duplexer 540 with the antenna 590, or operatively disconnect all of the duplexer 520, the second duplexer 530, and the third duplexer 540 from the antenna 590.

Referring to FIG. 6, the FEM 600 may be operatively coupled to the antenna 690. In an example, the FEM 600 may include a duplexer 620 that can be connected to the antenna 690.

The duplexer 620 may include a filter that passes a signal within a frequency range of the NR standard of the third frequency band.

Referring to FIG. 7, the FEM 700 may include a PA 710, a first switch 750, a first connector 720, a second connector 730, and a third connector 740.

According to an example, the FEM 700 may perform the operation of the third FEM 430 of FIG. 4b and the operation of the switch 490 of FIG. 4b. For example, the FEM 700 may dispose the third FEM 430 of FIG. 4b including the switch 490 of FIG. 4b. For example, the FEM 700 may include a substrate 701, the PA 710 disposed on the substrate 701, a first connector 720 disposed on an edge of the substrate 701, a second terminal disposed on the edge of the substrate 701, a third connector 740 disposed on the edge of the substrate 701, and/or a switch 750 on the substrate 701 configured to selectively provide the first voltage Vcc1 or the second voltage Vcc2 to the PA 710. The first power supply circuit 401 may provide the first voltage Vcc1 to the PA 710 . The first voltage Vcc1 may be different from the second voltage Vcc2.

The first switch 750 may include a first terminal 750a, a second terminal 750b, and a third terminal 750c. The first switch 750 includes a first terminal 750a connected to the PA 710 and the third connector 740, a second terminal 750b connected to the first power supply circuit 402, and a third terminal 750c connected to the second power supply circuit 402. The first switch 750 may be configured to connect the first terminal 750a and the second terminal 750b, in order to transmit a signal using the third PA 431, the fourth PA 441, the fifth PA 451 and/or the sixth PA 461 operating based on the voltage of the first power supply circuit 401, while transmitting a signal using the second PA 421. The first switch 750 may be configured to connect the first terminal 750a and the third terminal 750c in order to transmit a signal using the third PA 431, the fourth PA 441, the fifth PA 451 and/or the sixth PA 461 operating based on the voltage of the second power supply circuit 402, while transmitting a signal using the first PA 411. The switch 490 may be referred to as a routing component in terms of setting one of several paths.

According to an example, the first connector 720 may be configured to provide the first voltage Vcc1 provided from the first power supply circuit 401 to the PA(710)(e.g., the third PA 431 of FIG. 4b). The first switch 750 may provide an first electrical connection 751 from the first connector 720 to the PA 710. The first connector 720 may be electrically connected to the first power supply circuit 401 outside the FEM 700 configured to provide the first voltage Vcc1 for operating the PA 710 within an operating range. A connector may be referred to as a node in that it is disposed between two or more circuit elements (e.g., switch, PA, or FEM). For example, the first connector 720 may be referred to as a first node in that it is disposed between the first PA 411 and PA 710(e.g., the third PA 431 of FIG. 4b). The second connector 730 may be referred to as a second node in that it is disposed between the second PA 421 and the third PA 710. The third connector 740 may be referred to as a third node in that it is disposed between the switch 750 (or the PA 710) and the fourth PA 441.

According to an example, the second connector 730 may be configured to provide the second voltage Vcc2 provided from the second power supply circuit 402. The first switch 750 may provide a second electrical connection 752 from the second connector 730 to the PA 710. The second connector 730 may be electrically connected to the second power supply circuit 402 outside the FEM 700 configured to provide the second voltage Vcc2 for operating the PA 710 within an operating range.

According to an example, the third connector 740 may be electrically connected to the PA 710 inside the FEM 700. According to an example, the third connector 740 may be electrically connected to a PA (e.g., the fourth PA 441, the fifth PA 451, or the sixth PA 461 of FIG. 4) in another FEM (e.g., the fourth FEM 440, the fifth FEM 450, or the sixth FEM 460 of FIG. 4) outside the FEM 700 (e.g., the third FEM 430 of FIG. 4). The third connector 740 may provide an electrical connection 753 connected from the node N between the first connector 720 and the second connector 730 and the PA 710 or the switch 750, to the outside. The electrical connection 753 may be a path for supplying the voltage Vcc1 or Vcc2 supplied to the node N, to a PA in another FEM. While the first voltage Vcc1 is provided from the first power supply circuit 401 through the first electrical connection 751 to the PA 710 in the FEM 700, the third connector 740 may provide the first voltage Vcc1 to the PA (e.g., the fourth PA 441, the fifth PA 451, or the sixth PA 461) in the other FEM (e.g., the fourth FEM 440, the fifth FEM 450, or the sixth FEM 460). While the first voltage from the first power supply circuit 401 is supplied to the PA 710, the voltage of the first connector 720 may be different from the voltage of the third connector 740. For example, the voltage of the first connector 720, which is an input terminal, may be different from the voltage of the third connector 740, which is an output terminal, due to a voltage drop caused by the switch 750. The voltage of the third connector 740 may be lower than that of the first connector 720.

According to an example, The third connector 740 may be configured to provide the second voltage to the PA (e.g., the fourth PA 441, the fifth PA 451, or the sixth PA 461) in the other FEM (e.g., the fourth FEM 440, the fifth FEM 450, or the sixth FEM 460), while the second voltage Vcc2 is provided from the second power supply circuit 402 through the second electrical connection 752 to the PA 710 in the FEM 700. While the second voltage from the second power supply circuit 402 is supplied to the PA 710, the voltage of the second connector 730 may be different from the voltage of the third connector 740. For example, the voltage of the second connector 730, which is an input terminal, may be different from the voltage of the third connector 740, which is an output terminal, due to a voltage drop caused by the switch 750. The voltage of the third connector 740 may be lower than that of the second connector 730.

According to an example, while power from the first power supply circuit 401 is provided to the PA 710 through the first connection formed using the switch 750, the third connector 740 may provide the power from the first power supply circuit 401 to another PA (e.g., the fourth PA 441, the fifth PA 451, or the sixth PA 461). While power from the second power supply circuit 402 is provided to the PA 710 through the second connection formed using the switch 750, the third connector 740 may provide the power from the second power supply circuit 402 to another PA (e.g., the fourth PA 441, the fifth PA 451, or the sixth PA 461).

According to an example, the first switch 750 may be disposed in the FEM 700 and may be configured to provide a first electrical connection 751 between the first connector 720 and the PA 710 or a second electrical connection 752 between the second connector 730 and the PA 710. The first switch 750 may have a first state of establishing the first electrical connection 751 between the first connector 720 and the PA 710, a second state of establishing the second electrical connection 752 between the second connector 730 and the PA 710, and a third state of disconnecting both the first electrical connection 751 and the second electrical connection 752 from the PA 710. According to an example, the first switch 750 may connect a path from the fourth PA 441 and the first connector 720 (or the first pad) to provide a voltage Vcc1 obtained to the first connector 720 from the first power supply circuit 401 to the pad of the fourth FEM(e.g., the fourth FEM 440 of FIG. 4), while transmitting a signal using the second PA 421 that operates based on a voltage Vcc2 from the second power supply circuit 402. The first switch 750 may connect the path of the fourth PA 441 and the second connector 730 (or the second pad) to provide a voltage Vcc2 obtained to the second connector 730 from the second power supply circuit 402 to the pad of the fourth FEM 440, while transmitting a signal using the first PA 411 that operates based on a voltage Vcc1 from the first power supply circuit 401. The first switch 750 has been described as having a first state, a second state, and a third state, but is not limited thereto. The first switch 750 may have a fourth state in which the first electrical connection 751 and the second electrical connection 752 are simultaneously formed.

According to an example, instead of arranging a power switch in each of components (e.g., the third FEM 430, the fourth FEM 440, the fifth FEM 450, and/or the sixth FEM 460), which have to receive power from the first power supply circuit 401 and the second power supply circuit 402, the first switch 750 may be disposed in one FEM 700 (e.g., the third FEM 430). The first switch 750 disposed in one FEM 700 may electrically connect the first power supply circuit 401 to the third FEM 430, the fourth FEM 440, the fifth FEM 450, or the sixth FEM 460, electrically connect the second power supply circuit 402 to the third FEM 430, the fourth FEM 440, the fifth FEM 450, and/or the sixth FEM 460, or electrically disconnect the third FEM 430, the fourth FEM 440, the fifth FEM 450, and/or the sixth FEM 460 from the first power supply circuit 401 and the second power supply circuit 402. As described above, the first switch 750 may secure antenna freedom for supporting various frequency bands, through electrical connection between the third FEM 430, the fourth FEM 440, the fifth FEM 450 and/or the sixth FEM 460 and the first power supply circuit 401 or the second power supply circuit 402.

According to an example, the PA 710 may be configured to set transmission power of a signal. The PA 710 may set the transmission power of the signal based on the first voltage Vcc1 or the second voltage Vcc2. For example, the PA 710 may receive a voltage (e.g., the first voltage Vcc1 or the second voltage Vcc2) from a power supply circuit (e.g., the first power supply circuit 401 or the second power supply circuit 402) outside the FEM 700. In response to receiving the voltage, the PA 710 may transmit the transmission power of the signal to the antenna A.

Referring to FIG. 8, the FEM 800 may further include a second switch 760 in the FEM 700 of FIG. 7. The second switch 760 may be disposed in the FEM 800 and may be configured to provide a third electrical connection 753 between the first switch 750 and the third connector 740 and a fourth electrical connection 754 between the first switch 750 and the PA 710. The second switch 760 may have a first state of establishing a third electrical connection 753 between the third connector 740 and the first switch 750, a second state establishing a fourth electrical connection 754 between the first switch 750 and the PA, and a third state of disconnecting both the third electrical connection 753 and the fourth electrical connection 754. According to an example, the second switch 760 include an input terminal connected to a signal path extending from the first switch 750, the first output terminal connected to third FEM 430, and the second output terminal connected to the fourth FEM 440. The second switch 760 may be configured to be selectively set to a first routing state in which a signal received at the input terminal is routed to the first output terminal or a second routing state in which a signal received at the input terminal is routed to the second output terminal. The processor 400 may be configured to control a routing state of the second switch 760 to route the voltage transmitted through the input terminal to one of the third FEM 430 and the fourth FEM 440.

According to an example, when the second switch 760 is configured to provide a voltage to a PA (e.g., the fourth PA 441, the fifth PA 451, or the sixth PA 461 of FIG. 4b) included in another FEM (e.g., the fourth FEM 440, the fifth FEM 450, or the sixth FEM 460) outside the FEM 700, the second switch 760 may be configured not to provide the voltage to the PA 710, thereby increasing its stability. The second switch 760 can be configured not to provide the voltage to the PA outside the FEM 700 while the voltage is provided to the PA 710 inside the FEM 700, thereby leading to less influence of the line extending from the PA 710.

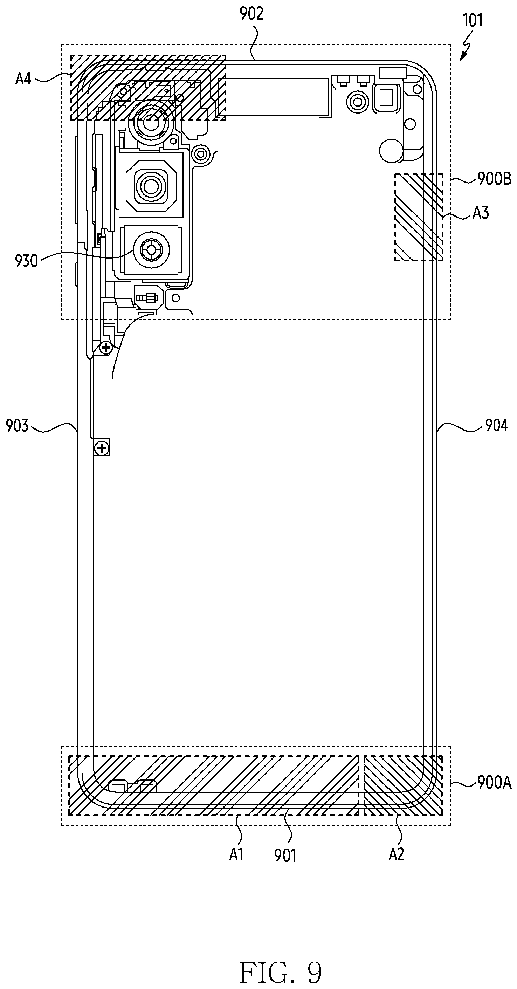

FIG. 9 illustrates an example of arrangement of antenna modules electrically connected to FEMs in an electronic device according to an example.

Referring to FIG. 9, the electronic device 101 may include a first side surface 901, a second side surface 902 substantially parallel to the first side surface 901, a third side surface 903 substantially perpendicular to the first side surface 901 and extending from one end of the first side surface 901 to one end of the second side surface 902, and a fourth side surface 904 substantially perpendicular to the first side surface 901 and extending from other end of the first side surface 901 to other end of the second side surface 902. The lengths of the first side surface 901 and the second side surface 902 may be smaller than the lengths of the third side surface 903 and the fourth side surface 904. A first antenna A1 and/or a second antenna A2 may be disposed on the first side surface 901 of the first side surface 901 and the second side surface 902 both having a short length. For example, the first antenna A1 and/or the second antenna A2 may be disposed at a position less affected by a user's hands when the user of the electronic device 101 grips the electronic device 101. The first antenna A1 and/or the second antenna A2 may be disposed in a first area 900A. The first area 900A may be an area located close to the user's jaw (or mouth) when the user holds the electronic device 101 for a phone call. A third antenna A3 and/or a fourth antenna A4 may be disposed in a second area 900B. The second area 900B may be an area located close to the user's ear when the user holds the electronic device 101 for a phone call. The electronic device 101 may further include a housing including a sidewall forming a side surface. A conductive portion of the sidewalls disposed in the second area 900B may be configured to operate as at least a part of the third antenna A3 and the fourth antenna A4.

According to an example, one of the first antenna A1 and the second antenna A2 may operate for communication with an external electronic device, and one of the remaining antennas other than the above antenna may also operate. For example, when the first antenna A1 operates, one of the second antenna A2, the third antenna A3, and the fourth antenna A4 may operate together with the first antenna A1. As another example, when the second antenna A2 operates, one of the first antenna A1, the third antenna A3, and the fourth antenna A4 may operate together with the second antenna A2.

According to an example, the electronic device 101 may include a plurality of antennas A1, A2, A3, and A4. The frequency ranges supported by each of the plurality of antennas A1, A2, A3, and A4 may be different from each other. For example, the first antenna A1 may be electrically connected to a first FEM (e.g., the first FEM 410 of FIG. 4a or FIG. 4b) supporting a signal within a first frequency range. The second antenna A2 may be electrically connected to a second FEM (e.g., the second FEM 420 of FIG. 4a or FIG. 4b) supporting the second frequency range. The third antenna A3 and/or the fourth antenna A4 may be selectively connected to one of multiple FEMs (e.g., the third FEM 430 or the fourth FEM 440 of FIG. 4a or FIG. 4b). The third antenna A3 may be connected to a third FEM (e.g., the third FEM 430 of FIG. 4a or FIG. 4b) or a fourth FEM (e.g., the fourth FEM 440 of FIG. 4a or FIG. 4b). The third antenna A3 may transmit a signal in the third frequency range based on connection with the third FEM 430, and the third antenna may transmit a signal in the fourth frequency range based on the connection with the fourth FEM 440. For example, the fourth antenna A4 may be connected to a fifth FEM (e.g., the fifth FEM 450 of FIG. 4a or FIG. 4b) or a sixth FEM (e.g., the sixth FEM 460 of FIG. 4a or FIG. 4b). The fourth antenna A4 may transmit a signal (e.g., n77 or n79 of the NR standard) in a fifth frequency range based on connection with the fifth FEM 450, and the fourth antenna A4 may transmit a signal (e.g., n77 or n79 of the NR standard) in a sixth frequency range based on connection with the sixth FEM 460.

According to an example, while a signal is transmitted to a first external electronic device using a first antenna connected to a first PA (e.g., the first PA 411 of FIG. 4a or FIG. 4b) and a signal is transmitted to a second external electronic device using a third antenna A3 connected to a third PA (e.g., the third PA 431 of FIG. 4a or FIG. 4b), the processor (e.g., the processor 400 of FIG. 4a or FIG. 4b) may be configured to transmit a signal to the second external electronic device using a second antenna A2 through the second PA, based on identifying a state change in the electronic device 101. The state change in the electronic device 101 may mean a state change that affects antenna radiation performance by a user's gripping. In case where the electronic device 101 is a foldable electronic device, the state change in the electronic device 101 may mean a change of a folding or unfolding state of the foldable electronic device.

For example, an example of a dual connectivity according to the structure of the FEMs of FIG. 4a or FIG. 4b and the antenna arrangement structure of FIG. 9 may be illustrated in the table below.

**<Table 2>**

| **First Communication Scheme (e.g., LTE)** | | | | **Second Communication Scheme (e.g., NR)** | | | |
|---|---|---|---|---|---|---|---|
| **Frequency Band** | **PA** | **Power Supply Circuit** | **Antenna Location** | **Frequency Band** | **PA** | **Power Supply Circuit** | **Antenna Location** |
| Low | First PA 411 | First Power Supply Circuit 401 | Lower Part | Low | Fifth PA 451 | Second Power Supply Circuit 402 | Upper Part |
| Low | First PA 411 | First Power Supply Circuit 401 | Lower Part | Mid | Second PA 421 | Second Power Supply Circuit 402 | Lower Part |
| | | | | | Sixth PA 461 | Second Power Supply Circuit 402 | Upper Part |
| Low | First PA 411 | First Power Supply Circuit 401 | Lower Part | High | Second PA 421 | Second Power Supply Circuit 402 | Lower Part |
| | | | | | Sixth PA 461 | Second Power Supply Circuit 402 | Upper Part |
| Mid | Secon d PA 421 | Second Power Supply Circuit 402 | Lower Part | Low | First PA 411 | First Power Supply Circuit 401 | Lower Part |
| | | | | | Fifth PA 451 | First Power Supply Circuit 401 | Upper Part |
| Mid | Secon d PA 421 | Second Power Supply Circuit 402 | Lower Part | Mid | Sixth PA 461 | First Power Supply Circuit 401 | Upper Part |
| Mid | Secon d PA 421 | Second Power Supply Circuit 402 | Lower Part | High | Sixth PA 461 | First Power Supply Circuit 401 | Upper Part |
| High | Secon d PA 421 | Second Power Supply Circuit 402 | Lower Part | Low | First PA 411 | First Power Supply Circuit 401 | Lower Part |
| | | | | | Fifth PA 451 | First Power Supply Circuit 401 | Upper Part |
| High | Secon d PA 421 | Second Power Supply Circuit 402 | Lower Part | Mid | Sixth PA 461 | First Power Supply Circuit 401 | Upper Part |
| High | Secon d PA 421 | Second Power Supply Circuit 402 | Lower Part | High | Sixth PA 461 | First Power Supply Circuit 401 | Upper Part |
| Low | First PA 411 | First Power Supply Circuit 401 | Lower Part | UHB | Third PA 431/Fourt h PA 441 | Second Power Supply Circuit 402 | Upper Part |
| Mid | Secon d PA 421 | Second Power Supply Circuit 402 | Lower Part | UHB | Third PA 431/Fourt h PA 441 | First Power Supply Circuit 401 | Upper Part |
| High | Secon d PA 421 | Second Power Supply Circuit 402 | Lower Part | UHB | Third PA 431/Fourt h PA 441 | First Power Supply Circuit 401 | Upper Part |

Referring to the above table and FIGS. 4a, FIG. 4b and 9, through a switch (e.g., the switch 490 of FIG. 4a or FIG. 4b, or the first switch 750 of FIG. 7), the electronic device 101 may provide an electrical connection between the third PA 431 of the third FEM 430, the fourth PA 441 of the fourth FEM 440, the fifth PA 451 of the fifth FEM 450, or the sixth PA 461 of the sixth FEM 460 and the first power supply circuit 401, or provide an electrical connection between the third PA 431 of the third FEM 430, the fourth PA 441 of the fourth FEM 440, the fifth PA 451 of the fifth FEM 450, or the sixth PA 461 of the sixth FEM 460 and the second power supply circuit 402. When providing the first voltage to the first PA 411 connected to the first antenna A1 located in the first area 900A through the first power supply circuit 401, the processor (e.g., the processor 400 of FIG. 4a or FIG. 4b) may be configured to provide the second voltage to the third PA 431 of the third FEM 430, the fourth PA 441 of the fourth FEM 440, the fifth PA 451 of the fifth FEM 450, or the sixth PA 461 of the sixth FEM 460 connected to the third antenna A3 or the fourth antenna A4 located in the second area 900B, through the second power supply circuit 402. When providing the second voltage to the second PA 412 connected to the second antenna A2 located at the lower end through the second power supply circuit 402, the processor 400 may be configured to provide the first voltage to the third PA 431 of the third FEM 430, the fourth PA 441 of the fourth FEM 440, the fifth PA 451 of the fifth FEM 450, or the sixth PA 461 of the sixth FEM 460 connected to the third antenna A3 or the fourth antenna A4 located at the upper end, through the first power supply circuit 401. According to an example, the first antenna A1 and the second antenna A2 capable of supporting LTE may be disposed at a lower end of the electronic device 101 where the first side surface 901 is located. If the LTE connection is unstable while the electronic device 101 operates in EN-DC, it will also affect communication using NR, and thus the antennas A1 and A2 supporting LTE may be disposed in the lower end. In an example, each of the antennas A1 and A2 disposed at the lower end may be connected to a power supply circuit (e.g., the first power supply circuit 401 or the second power supply circuit 402), respectively. For example, the first power supply circuit 401 connected to the first antenna A1 may be connected to the third antenna A3 and the fourth antenna A4. The second power supply circuit 402 connected to the second antenna A2 may be connected to the third antenna A3 and the fourth antenna A4. The third antenna A3 and the fourth antenna A4 may be electrically connected to the first power supply circuit 401 or the second power supply circuit 402 depending on the operation of the first antenna A1 or the second antenna A2. For example, while the first power supply circuit 401 is connected to the first antenna A1, the second power supply circuit 402 may be connected to the third antenna A3 and the fourth antenna A4 through a switch (e.g., the switch 490 of FIG. 4a or FIG. 4b). While the second power supply circuit 402 is connected to the second antenna A2, the first power supply circuit 401 may be connected to the third antenna A3 and the fourth antenna A4 through the switch 490.

According to the above-described embodiments, the electronic device 101 can increase the degree of freedom of the antennas by connecting FEMs requiring connection with multiple power supply circuits 401 and 402, through the switch 490 disposed outside the FEM or the first switch 750 disposed inside one FEM of a plurality of FEMs. The electronic device 101 does not have a switch in every one of the plurality of FEMs, and may arrange a switch in only one selected FEM or a switch outside the FEM, thereby reducing the dimension of the FEM and reducing the number of switches. Consequently, it is possible to greatly reduce related manufacturing costs.

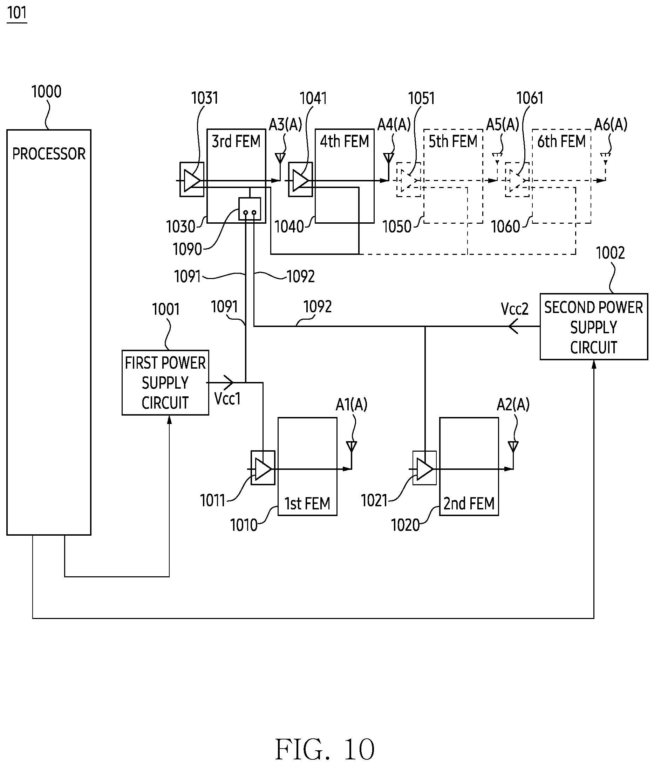

FIG. 10 is a simplified block diagram of an exemplary electronic device including a PA disposed outside of a FEM according to an example.

Referring to FIG 10, the electronic device 101(e.g., the electronic device 101) may include a processor 1000, a first power supply circuit 1001, a second power supply circuit 1002, a first FEM 1010, a second FEM 1020, a third FEM 1030, a fourth FEM 1040, a fifth FEM 1050, and/or a sixth FEM 1060. In an example, the processor 1000 may include the processor 120 illustrated in FIG. 1. In an example, the processor 1000 may include at least one of the processor 120, the first communication processor 212, the second communication processor 214, the first RFIC 222, the second RFIC 224, the third RFIC 226, the fourth RFIC 228, as illustrated in FIG. 2 or transceiver.

The FEMs 1010, 1020, 1030, 1040, 1050, and 1060 may include at least one filter (e.g., the first filter 521, the second filter 531, or the third filter 541 of FIG. 5) for processing the signal transmitted through one of the antennas A1, A2, A3, A4, A5, and A6, a duplexer (e.g., the first duplexer 520, the second duplexer 530, or the third duplexer 540 of FIG. 5) and/or a switch(e.g., the switch 550 and/or the switch 580 of FIG. 5).

A PA (e.g., The first PA 411, the second PA 421, the third PA 431, the fourth PA 441, the fifth PA 451, and/or the sixth PA 461) and/or a switch 1090 may be disposed outside the FEM.

At least one power supply circuit (e.g., the first power supply circuit 1001 or the second power supply circuit 1002) may variably supply the voltage to the Pas, based on control of the processor 1000 and/or a radio frequency integrated circuit (RFIC) (not shown). According to an example, the voltage for the dynamic operating range of the PAs 1011, 1021, 1031, 1041, 1051, and 1061 may be set by the processor 1000. The voltage may be also set by the radio frequency integrated circuit (RFIC) (not shown) connected to the processor 1000 and each of the FEMs 1010, 1020, 1030, 1040, 1050, and 1060.

According to an example, the at least one power supply circuit may include the first power supply circuit 1001 and/or the second power supply circuit 1002. For example, each of the PAs 1031, 1041, 1051, and 1061 connected to each of some FEMs 1030, 1040, 1050, and 1060 amongst the FEMs may receive the voltage or the power from the first power supply circuit 1001 or the second power supply circuit 1002. For example, the first PA 1011 connected to the first FEM 1010 amongst the FEMs may receive the first voltage Vcc1 or a power from the first power supply circuit 1001. For example, the second PA 1021 connected to the second FEM 1020 amongst the FEMs may receive the second voltage Vcc2 or a power from the second power supply circuit 1002. For example, the first power supply circuit 1001 may be configured to supply the first voltage Vcc1 to the PAs 1011, 1031, 1041, 1051, and 1061 connected to each of the first FEM 1010, the third FEM 1030, the fourth FEM 1040, the fifth FEM 1050, and the sixth FEM 1060. For example, the second power supply circuit 1002 may be configured to supply the second voltage Vcc2 to the PAs 1021, 1031, 1041, 1051, and 1061 connected to each of the first FEM 1020, the third FEM 1030, the fourth FEM 1040, the fifth FEM 1050, and the sixth FEM 1060. The first PA 1011 may receive the power from the first power supply circuit 1001. The second PA 1012 may receive the power from the second power supply circuit 1002. Each of the Pas 1031, 1041, 1051, and 1061 may be receive the power from the first power supply circuit 1001 or the power supply circuit 1002.

According to an example, the processor 1000 is configured to operate one PA(e.g., the third PA 1031) amongst the Pas 1011, 1031, 1041, 1051, 1061 supplied with the first voltage Vcc1 from the first power supply circuit 1001 and to operate the second PA 1021 supplied with the second voltage Vcc2 from the second power supply circuit 1002.

According to an example, in order to supply the first voltage Vcc1 supplied from the first power supply circuit 1001 and the second voltage Vcc2 supplied from the second power supply circuit 1002, to a designated FEM, the switch 1090 may be operatively connected to the processor 1000. The switch 1090 may be controlled by the processor 1000. The processor 1000 may include at least one of processor 120, the first communication processor 212, the second communication processor 214, the first RFIC 222, the second RFIC 224, the third RFIC 226, the fourth RFIC 228, as illustrated in FIG. 2 or transceiver. The switch 1090 may be controlled by the processor 1000. The switch 1090 may selectively connect the third PA 1031, the fourth PA 1041, the fifth PA 1051, and the sixth PA 1061 to either the first power supply circuit 1001 or the second power supply circuit 1002. The first power supply circuit 1001 may be always electrically connected to the first PA 1011 and the first power supply circuit 1001 may be selectively connected to the third PA 1031, the fourth PA 1041, the fifth PA 1051, and the sixth PA 1061, through the switch 1090 and a path 1091 connected to the switch 1090. The second power supply circuit 1002 may be always electrically connected to the second PA 1012 and the second power supply circuit 1002 may be selectively connected to the third PA 1031, the fourth PA 1041, the fifth PA 1051, and the sixth PA 1061, through the switch 1090 and a path 1092 connected to the switch 1090. The third PA 1031 and the switch 1090 may be configured as one component. The switch 1090 may be disposed on a substrate on which the third PA 1031 is disposed. The first terminal 1090a of the switch 1090 or the first pad may be connected to the third PA 1031. The second terminal 1090b of the switch 1090 or the second pad may be connected to the path 1091 and the third terminal 1090c of the switch 1090 or the third pad may be connected to the path 1092. The switch 1090 is not limited thereto and may be formed as a separate component from the third PA 1031.

According to an example, while providing the voltage Vcc1 from the first power supply circuit 1001 to the first PA 1011, the processor 1000 may be configured to provide the voltage from the second power supply circuit 1002 to the remaining Pas 1021, 1031, 1041, 1051, and 1061 except for the first PA 1011 by using the switch 1090. While providing the voltage Vcc2 from the second power supply circuit 1002 to the second PA 1021, the processor 1000 may be configured to provide the voltage from the first power supply circuit 1001 to the remaining Pas 1011, 1031, 1041, 1051, and 1061 except for the second PA 1012 by using the switch 1090.

According to an example, the electronic device 101 may include the FEMs 1010, 1020, 1030, 1040, 1050, 1060 disposed outside Pas 1011, 1021, 1031, 1041, 1051, 1061. The disclosure was described that all PAs are disposed outside the FEMs 1010, 1020, 1030, 1040, 1050, and 1060, but are not limited thereto. Some of the FEMs 1010, 1020, 1030, 1040, 1050, and 1060 may include a PA in the some FEMs. For example, the first FEM 1010 and the second FEM 1020 may include Pas like the first FEM 410 and the second Fem 420 of FIG. 4a or FIG. 4b. The electronic device 101 may be same as or similar to the electronic device 101 of FIG. 4b except that the PA is disposed outside the FEM. The operation of the processor 1000 may be the same as or similar to the operation of the processor 400 of FIG. 4A or 4B.

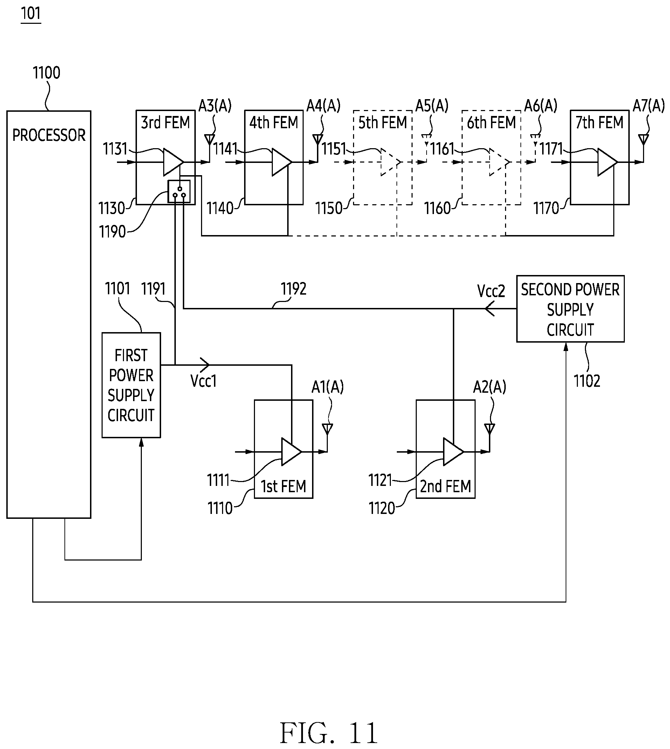

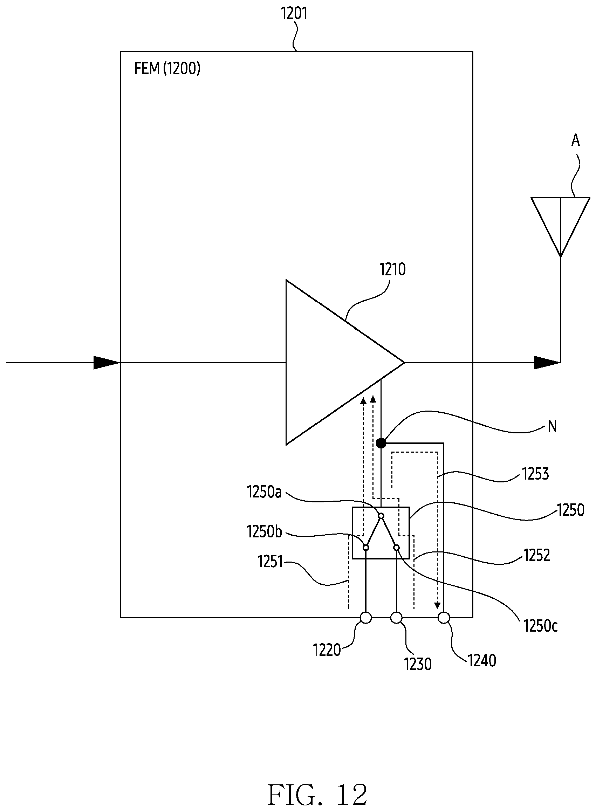

FIG. 11 is a simplified block diagram of an exemplary electronic device including an additional FEM. FIG. 12 illustrates an example of operation of a switch in an FEM inside an electronic device according to an example.

Referring to FIGS. 11 and 12, the electronic device 101(e.g., the electronic device 101 of FIG. 1) may include a processor 1100, a first power supply circuit 1101, a second power supply circuit 1102, a first FEM 1110, a second FEM 1120, a third FEM 1130, a fourth FEM 1140, a fifth FEM 1150, a sixth FEM 1160, a seventh FEM 1170, a first PA 1111, a second PA 1121, a third PA 1131, a fourth PA 1141, a fifth PA 1151, a sixth PA 1161 or a seventh PA 1171. In an example, the processor 1100 may include the processor 120 illustrated in the FIG. 1. In an example, the processor 1100 may include at least one of the processor 120, the first communication processor 212, the second communication processor 214, the first RFIC 222, the second RFIC 224, the third RFIC 226, the fourth RFIC 228, as illustrated in FIG. 2 or transceiver. The FEMs 1010, 1020, 1030, 1040, 1050, and 1060 may include components for processing the signal transmitted through at least one of the antennas A1, A2, A3, A4, A5, A6, and A7. Each of the FEMs 1110, 1120, 1130, 1140, 1150, 1160, 1170 may be connected to one of the antennas A1, A2, A3, A4, A5, A6, and A7.

According to an example, in the electronic device 101 of FIG. 4B, a seventh FEM 1170 and a seventh antenna A7 may be added. A description of the first power supply circuit 1101, the second power supply circuit 1102, the first FEM 1110, the second FEM 1120, the third FEM 1130, the fourth FEM 1140, the fifth FEM 1150, the sixth FEM 1160, the first PA 1011, the second PA 1021, the third PA 1031, the fourth PA 1041, the fifth PA 1051, or the sixth PA 1061 which are described in FIG. 4B is omitted.

According to an example, the seventh FEM 1170 and the seventh antenna may be a FEM for satellite communication and antennas for satellite communication that require high power. For example, a signal transmitted through the seventh antenna A7 may be used for a save our ship (SOS) service (or emergency service). For wide coverage of the signal, a range of transmit power obtained using the seventh PA 1171 may be higher than a range of transmit power obtained using the other PAs(e.g., the first PA 1111, the second PA 1121, the third PA 1131, the fourth PA 1141, the fifth PA 1151, or the sixth PA 1161).The intensity of a current used to obtain the transmit power of the signal transmitted through the antenna A7 using the seventh PA 1171 is higher than the maximum magnitude of the current obtainable from one of the first power supply circuit 1101 and the second power supply circuit 1102. For the transmit power of the signal transmitted through antenna A7, first power supply circuit 1101 and the second power supply circuit 1102 may be connected in parallel to the third FEM 1130 connected to the seventh PA 1171. For example, the voltage from the first power supply circuit 1101 and the voltage from the second power supply circuit 1102 may be provided to the seventh PA 1171 to obtain the transmit power of a signal transmitted through antenna A7. The seventh PA 1171 inside the seventh FEM 1170 may require higher power than the first PA 1111, the second PA 1121, the third PA 1131, the fourth PA 1141, the fifth PA 1151, and the sixth PA 1161. In order to supply required power to the seventh PA 1171, the switch 1190 may be controlled to supply power from the first power supply circuit 1101 and power from the second power supply circuit 1102 to the seventh PA 1171. While the switch 1190 is connected to the first power supply circuit 1101 to supply required power to the 7PA 1171, the switch 1190 may be connected to the second power supply circuit 1102. The switch 1190 may connect a path 1191 extending from the first power supply circuit 1101 and a path 1192 extending from the second power supply circuit 1102 to a path connected to the third PA 1131 and the fourth PA 1141, the 5th PA 1151, the 6th PA 1161 and/or the 7th PA 1171.

According to an example, the seventh PA 1171 inside the seventh FEM 1170 may require higher current capacity than the first PA 1111, the second PA 1121, the third PA 1131, the fourth PA 1141, the fifth PA 1151, and the sixth PA 1161. The switch 1190 may be controlled to supply one of the current supplied from the first power supply circuit 1101, the current supplied from the second power supply circuit 1102, and the sum of the current supplied from the first power supply circuit 1101 and the current supplied from the second power supply circuit 1102, to the third FEM 1130. The current supplied to the third FEM 1130 may be transferred to the seventh PA 1171 in the seventh FEM 1170.

According to an example, the switch 1190 may be the same component as the third FEM 1130. The switch 1190 may be a separate component disposed outside the third FEM 1130. The switch 1190 may be controlled to supply currents supplied from the first power supply circuit 1101 and the second power supply circuit 1102 to the seventh PA 1171, in order to supply the required current capacity to the seventh PA 1171.

Referring to FIG. 12, a FEM 1200 may be the third FEM 1130 of FIG. 11. The FEM 1200 may include a substrate 1201, PA 1210 disposed on the substrate 1201, a first connector (or pad, terminal) 1220, a second connector 1230, a third connector 1240 and/or a switch disposed on the substrate. The switch 1250 may be configured to supply the first voltage Vcc1 and/or the second voltage Vcc2 to PA 1210.

According to an example, the first voltage Vcc1 from the first power supply circuit 1101 may be supplied to the first connector 1220, the second voltage Vcc2 from the second power supply circuit 1102 may be supplied to the second connector 1230. The switch 1250 may include a first terminal 1250a connected to the PA 1210 and the third connector 1240, a second terminal 1250b connected to the first connector 1220, a third terminal 1250c connected to the second connector 1220. The switch 1250 may provide an electric connection 1251 connected from the first connector to the PA 1210. For example, the switch 1250 may provide a first electrical connection 1251 connecting the first power supply circuit 1101 external to the FEM 1200 and the PA 1210, by connecting the first terminal 1250a and the second terminal 1250b. The switch 1250 may provide an electrical connection 1252 from the second connector 1230 to the PA 1210. For example, the switch 1250 may provide a second electrical connection 1252 connecting the second power supply circuit 1102 external to the FEM 1200 and the PA 1210, by connecting the first terminal 1250a and the third terminal 1250c.

According to an example, the third connector 1240 may be electrically connected to the PA 1210 inside the FEM 1200 and another PA (e.g., eg, the fourth PA 1141, the fifth PA 1151, the sixth PA 1161, and/or the seventh PA 1171) in (or connected to) another FEM (e.g., the fourth FEM 1140, the fifth FEM 1150, the sixth FEM 1160, and/or the seventh FEM 1170) outside the FEM 1200. The third connector 1240 may provide a node N between the switch 1250 and the PA 1210 or a third electrical connection 1253 connected to the outside from the switch 1250. The third electrical connection 1253 may be a path for supplying the voltages Vcc1 and/or Vcc2 supplied to the node N to another PA.

According to an example, while the first voltage Vcc1 is provided from the first power supply circuit 1101 to the PA 1210 in the FEM 1200 through the first connection 1251, the third connector 1240 may be configured to provide the first voltage Vcc1 to the PA(e.g., the fourth PA 1141, the fifth PA 1151, the sixth PA 1161, or the seventh PA 1171) in (or connected to) the other FEM(e.g., the fourth FEM 1140, the fifth FEM 1150, the sixth FEM 1160, or the seventh FEM 1170). While the second voltage Vcc2 is provided from the second power supply circuit 1102 to the PA 1210 in the FEM 1200 through the second connection 1252, the third connector 1240 may be configured to be provide the second voltage Vcc2 to the PA(e.g., the fourth PA 1141, the fifth PA 1151, the sixth PA 1161, or the seventh PA 1171) in (or connected to) the other FEM(e.g., the fourth FEM 1140, the fifth FEM 1150, the sixth FEM 1160, or the seventh FEM 1170).

According to an example, the switch 1250 may be disposed in FEM 1200, and be configured to provide the first electric connection 1251 between the first connector 1220 and the PA 1210 or the second electric connection 1252 between the second connector 1230 and the PA 1210. The switch 1250 may be controlled by the processor 1100. The first switch 1250 may provide a first state forming the first electrical connection 1251 between the first terminal 1220 and the PA 1210, a second state forming the second electrical connection 1252 between the second connector 1230 and the PA 1210, a third state in which both the first electrical connection 1251 and the second electrical connection 1252 are disconnected, and a fourth state in which both the first electrical connection 1251 and the second electrical connection 1252 are formed. The switch 1250 has been described as being disposed within the FEM 1200 but is not limited thereto and the switch 1250 may be disposed outside the FEM 1200. According to an example, while transmitting a signal using the second PA 1121 operating based on the voltage Vcc2 from the second power supply circuit 1102, to transfer the voltage Vcc1 obtained at the first connector 1220 to the fourth FEM(e.g., the fourth FEM 1140 of FIG. 11), the switch 1250 connect a path(e.g., a path from the third connector 1240 to the node N) from the fourth PA 1141 to the second connector 1230.

In the fourth state of forming both the first electrical connection 1251 and the second electrical connection 1252, to transfer power or current of the first power supply circuit 1101 to a terminal (or connector) of a fourth FEM (e.g. the fourth FEM 1140 in FIG. 11) through the first connector 1220 and transfer power or current of the second power supply circuit 1102 to the terminal of the fourth FEM through the second connector 1210, the first switch 1250 may connect a path(e.g., a path from the third connector 1240 to the node N) from the fourth PA 1141 to the first connector 1220 (or the first pad), and connect the path from the fourth PA 1141 to the second connector 1230. For example, the first terminal 1250a of the switch 1250 may be connected to the second terminal 1250b and simultaneously connected to the third terminal 1250c. In the fourth state, the switch 1250 may be controlled to transfer power from the first power supply circuit 1101 and power from the second power supply to the third PA(e.g., the PA 1210 of FIG. 12, the fourth PA 1141, the fifth PA 1151, the sixth PA 1161 and/or the seventh PA 1171). For example, in the fourth state, the switch 1250 may be controlled to transmit a current greater than a current from the first power supply circuit 1101 or a current from the second power supply circuit 1102.

Referring to FIG. 11, the switch 1190 may support a multi-on mode, simultaneously providing a connection between the first terminal 1250a and the second terminal 1250b and a connection between the first terminal 1250a and the third terminal 1250c. The processor 1100 may be configured to control the switch 1190 to supply power from the first power supply circuit 1101 and power from the second power supply circuit 1102 to the seventh PA 1171, in order to use the antenna A7 requiring high power. For example, the processor 1100 may provide power from the first power supply circuit 1101 and power from the second power supply circuit 1102 to the seventh PA 1171 using the switch 1250, in order to establish a satellite communication channel through the seventh antenna A7. For example, the processor 1100 may be configured to connect the first terminal 1250a and the second terminal 1250b of the switch 1190 or 1250 and simultaneously connect the first terminal 1250a and the third terminal 1250c. Although the seventh antenna A7 has been described as an antenna for satellite communication, it is not limited thereto and may be an antenna supporting other frequency bands requiring high power. For the example, while a signal is being transmitted to at least one external electronic device (e.g., the first base station 310 or the second base station 330 of FIG. 3), the processor 1100 may be configured to receive a control message from the at least one external electronic device. The processor 1100 may identify a PA for a signal to be transmitted based on the control message. The processor 1100 may be configure to connect the seventh PA 1171 to the first power supply circuit 1101 and the second power supply circuit 1102 by controlling the switch 1190, based on that the identified PA is the seventh PA 1171.

According to an example, the switch 490 of FIG. 4a or FIG. 4b, the first switch 750 of FIG. 7 or FIG. 8 and/or the switch 1090 of FIG. 10 may support multi-on like the switch 1190 of FIG. 11 or the switch 1250 of FIG. 12.

According to the above-described embodiment, the electronic device 101 may support a frequency band requiring high output power, by simultaneously providing the power from the first power supply circuit 1101 and the power from the second power supply circuit 1102 to the third PA 1131, the fourth PA 1141, the fifth PA 1151, the sixth PA 1161, or the seventh PA 1171 through the switch 1190 or 1250. In a shadow area where it is difficult to establish a communication channel between the base station and the electronic device 101, the electronic device 1100 may establish a communication channel for communication with a satellite by simultaneously providing a plurality of supply voltages to the PA.

According to the above-described embodiment, an electronic device (e.g., the electronic device 101 of FIG. 1) may include at least one processor (e.g., the processor 120 of FIG. 1), a plurality of power supply circuits including a first power supply circuit (e.g., a first power supply circuit 401 of FIG. 4a or FIG. 4b) and a second power supply circuit (e.g., a second power supply circuit 402 of FIG. 4a or FIG. 4b), and a plurality of front end modules (FEMs) 410, 420, 430, 440, 450, and 460 electrically connected to the processor. The FEMs may include a first FEM (e.g., a first FEM 410 of FIG. 4a or FIG. 4b) electrically connected to the first power supply circuit and including a first power amplifier (PA) (e.g., a first PA 411 of FIG. 4a or FIG. 4b) configured to transmit a first RF signal, a second FEM (e.g., a second FEM 420 of FIG. 4a or FIG. 4b) electrically connected to the second power supply circuit and including a second PA (e.g., a second PA 421 of FIG. 4a or FIG. 4b) configured to transmit a second RF signal different from the first RF signal, a third FEM (e.g., a third FEM 430 of FIG. 4a or FIG. 4b) including a third PA configured to transmit a third RF signal distinct from the first RF signal and the second RF signal, and a switch configured to electrically connect one power supply circuit selected from among the first power supply circuit and the second power supply circuit to the third PA, the third FEM being configured to electrically connect the selected one power supply circuit to another FEM through an electrical path extending from a node between the third PA and the switch, and a fourth FEM (e.g., a fourth FEM 440 of FIG. 4a or FIG. 4b) including a fourth PA configured to transmit a fourth RF distinct from the first RF signal, the second RF signal and the third RF signal, the fourth FEM being electrically connected to the electrical path.

According to an example, the at least one processor may be configured to, based on transmitting a signal using the first PA operating based on a first voltage provided from the first power supply circuit through the switch, provide a first connection state electrically connecting the second power supply circuit to the third PA and the fourth PA through the switch, to transmit a signal using the third PA or the fourth PA operating based on a second voltage provided from the second power supply circuit, and based on transmitting a signal using the second PA operating based on the second voltage provided from the second power supply circuit, provide a second connection state electrically connecting the first power supply circuit to the third PA and the fourth PA through the switch, to transmit a signal using the third PA or the fourth PA operating based on the first voltage provided from the first power supply circuit. According to an embodiment, the processor may be configured to simultaneously transmit one selected from among the third RF signal or the fourth RF signal together with the first RF signal in the first connection state, or simultaneously transmit one selected from among the third RF signal or the fourth RF signal together with the second RF signal in the second connected state.

According to an example, the electronic device may further include a plurality of antennas (e.g., a first antenna A1, a second antenna A2, a third antenna A3, a fourth antenna A4, a fifth antenna A5, and a sixth antenna A6 of FIG. 4a or FIG. 4b) including a first antenna electrically connected with the first PA, a second antenna electrically connected with the second PA, a third antenna electrically connected with the third PA, and a fourth antenna connected with the fourth PA.

According to an example, the third antenna or the fourth antenna may be disposed on one side of the electronic device.

According to an example, the electronic device may further include a sidewall forming a side surface of the electronic device.

According to an example, the conductive portion of the sidewall disposed on the one side may be configured to operate as at least a portion of one of the third antenna or the fourth antenna.

According to an example, the first antenna or the second antenna may be disposed on another side opposite to the one side of the electronic device.

According to an example, the at least one processor may be further configured to support dual connectivity or carrier aggregation, by simultaneously transmitting a selected one of the third RF signal or the fourth RF signal and the first RF signal in the first connection state or simultaneously transmitting the selected one of the third RF signal or the fourth RF signal and the second RF signal in the second connection state.

According to an example, the at least one processor may be further configured to, based on transmitting a signal using the first PA operating based on a first voltage provided from the first power supply circuit, electrically connect the third PA and the fourth PA with the second power supply circuit through the switch to transmit a signal to the outside using the third PA or the fourth PA operating based on a second voltage provided from the second power supply circuit.

According to an example, at least one processor may be further configured to, based on transmitting a signal using the second PA operating based on a second voltage provided from the second power supply circuit, electrically connect the third PA and the fourth PA with the first power supply circuit through the switch to transmit a signal to the outside using the third PA or the fourth PA operating based on a first voltage provided from the first power supply circuit.

According to an example, the at least one processor may be further configured to receive a control message from a first external electronic device, while a signal is transmitted to the first external electronic device using the first PA.

According to an example, the at least one processor may be further configured to, based on the control message, while transmitting the signal using the first PA, identify a PA for another signal distinct from the signal, from among the second PA, the third PA, and the fourth PA.

According to an example, the at least one processor may be further configured to electrically connect the second power supply circuit to the third PA and the fourth PA through the switch, when the identified PA is determined as the third PA or the fourth PA.

According to an example, the signal transmitted using the first PA may be transmitted to the first external electronic device supporting a first communication scheme according to the first communication scheme, and the signal transmitted using the identified PA among the second PA, the third PA, or the fourth PA may be transmitted to a second external electronic device supporting a second communication scheme distinct from the first communication scheme according to the second communication scheme, the second external electronic device being distinct from the first external electronic device.

According to an example, the at least one processor may be configured to, based on the control message, electrically connect the second power supply circuit with the third PA and the fourth PA through the switch and inactivate the fourth PA, based on identifying that a PA for a signal to be transmitted to the second external electronic device according to the second communication scheme is the third PA.

According to an example, the at least one processor may be configured to, based on the control message, electrically connect the second power supply circuit with the third PA and the fourth PA through the switch and inactivate the third PA, based on identifying that the PA for the signal to be transmitted to the second external electronic device according to the second communication scheme is the fourth PA.

According to an example, the at least one processor may be configured to, based on the control message, refrain from electrically connecting the second power supply circuit with the third PA and the fourth PA through the switch, based on identifying that the PA for the signal to be transmitted to the second external electronic device according to the second communication scheme is the second PA.

According to an example, the at least one processor may be configured to receive a control message related to a signal to be transmitted, from the first external electronic device, while a signal is transmitted to the first external electronic device using the second PA, and based on the control message, identify a PA for a signal to be transmitted while the signal is transmitted using the second PA, from among the first PA, the third PA, and the fourth PA.

According to an example, the at least one processor may be configured to electrically connect the first power supply circuit with the third PA and the fourth PA through the switch, on a condition that the identified PA is determined as the third PA or the fourth PA.

According to an example, the at least one processor may be configured so that the signal transmitted using the second PA is transmitted to the first external electronic device according to the first communication scheme.

According to an example, the at least one processor may be configured so that the signal transmitted using the PA identified among the first PA, the third PA, or the fourth PA is transmitted to a second external electronic device distinct from the first external electronic device, according to a second communication scheme distinct from the first communication scheme.

According to an example, the at least one processor may be configured to, based on the control message, supply a voltage from the second power supply circuit through the switch to the third PA and the fourth PA, based on identifying that a PA for a signal to be transmitted to the second external electronic device according to the second communication scheme is the third PA.

According to an example, the at least one processor may be configured to, based on the control message, supply a voltage from the second power supply circuit through the switch to the third PA and the fourth PA, based on identifying that the PA for the signal to be transmitted to the second external electronic device according to the second communication scheme is the fourth PA.

According to an example, the at least one processor may be configured to, based on the control message, refrain from supplying a voltage from the second power supply circuit through the switch to the third PA and the fourth PA, based on identifying that the PA for the signal to be transmitted to the second external electronic device according to the second communication scheme is the second PA.

According to an example, the third FEM may include a first terminal (e.g., a first connector 720 of FIG. 7) configured to provide a first voltage provided from the first power supply circuit, a second terminal (e.g., a second connector 730 of FIG. 7) configured to provide a second voltage provided from the second power supply circuit, and a third terminal (e.g., a third connector 740 of FIG. 7) connected to the third PA.

According to an example, the switch in the third FEM may be configured to provide a first electrical connection between the first terminal and the third PA or a second electrical connection between the second terminal and the third PA.

According to an example, the third terminal may be configured to, while a first voltage provided from the first power supply circuit is provided to the third PA through the first electrical connection, provide the first voltage provided from the first power supply circuit to the fourth PA.

According to an example, the third terminal may be configured to, while a second voltage provided from the second power supply circuit is provided to the third PA through the second electrical connection, provide the second voltage provided from the second power supply circuit to the fourth PA.

According to an example, the third FEM may further include another switch distinct from the switch and configured to connect the third terminal with a node of the third PA to which a first voltage provided from the first power supply circuit or a second voltage provided from the second power supply circuit is applied.

According to an example, the at least one processor may be configured to receive a control message from a first external electronic device, while a signal is transmitted to the first external electronic device using the second PA, identify a PA for signal to be transmitted while the signal is transmitted using the first PA based on the control message, among the third PA and the fourth PA, electrically connect the third PA and the first terminal through the another switch, while electrically connecting the another switch and the first terminal through the switch based on identifying that the identified PA is the third PA, and refrain from electrically connecting the node of the third PA and the third terminal.

According to an example, the at least one processor may be configured to, while electrically connecting the another switch and the first terminal through the switch based on the identified PA being the fourth PA, electrically connect the node of the third PA and the third terminal through the another switch and refrain from electrically connecting the third PA and the first terminal.

According to an example, the first PA may be configured to set a first transmit power having a first frequency band, the second PA may be configured to set a second transmit power having a second frequency band, the third PA may be configured to set a third transmit power having a third frequency band, and the fourth PA may be configured to set a fourth transmit power having a fourth frequency band.

According to an example, the first frequency band may be spaced apart from the second frequency band, and the third frequency band may be spaced apart from the fourth frequency band.

According to an example, the first frequency band or the second frequency band may be lower than the third frequency band or the fourth frequency band.

According to an example, the first frequency band may include at least part of the third frequency band.

According to an example, the second frequency band may include at least part of the fourth frequency band.

According to an example, the electronic device may further include a housing forming an inner space thereof with a first side surface (e.g., a first side surface 901 of FIG. 9), a second side surface (e.g., a second side surface 902 of FIG. 9) parallel to the first side surface, a third side surface (e.g., a third side surface 903 of FIG. 9) extending from one end of the first side surface to one end of the second side surface in a direction perpendicular to the first side surface, and a fourth side surface (e.g., a fourth side surface 904 of FIG. 9) extending from the other end of the first side surface to the other end of the second side surface in a direction perpendicular to the first side surface.

According to an example, the electronic device may further include at least one first antenna (e.g., a first antenna A1 and/or a second antenna A2 of FIG. 9) formed by at least one conductive portion disposed on the first side surface, and at least one second antenna (e.g., a third antenna A3 and/or a fourth antenna A4 of FIG. 9) formed by at least one conductive portion disposed on the second side surface.

According to an example, the at least one first antenna may be configured to transmit a signal received from the first FEM or the second FEM to an external electronic device.

According to an example, the at least one second antenna may be configured to transmit a signal received from the third FEM or the fourth FEM to an external electronic device.

According to an example, the at least one processor may be configured to transmit a signal to the second external electronic device using the at least one first antenna through second PA, based on identifying a state of the electronic device, while a signal is transmitted to a first external electronic device using the first PA and the at least one first antenna and a signal is transmitted to a second external electronic device using the at least one second antenna through the third PA.

According to an example, the FEMs may further include a fifth FEM including a fifth PA connected to a first path and a second path of the switch. The switch may be controlled to connect the first power supply circuit to the third PA, the fourth PA, and the fifth PA and be controlled to connect the second power supply circuit to the third PA, the fourth PA and the fifth PA, to transmit a signal using the fifth PA operating based on a first voltage provided from the first power supply circuit and a second voltage provided from the second power supply circuit.

According to an example, an FEM may include a power amplifier (PA) configured to set a transmit power of a signal, a first terminal (e.g., a first connector 720 of FIG. 7) electrically connected to a first power supply circuit outside the FEM, the first terminal being configured to provide a first voltage for operating the PA within an operating range, a second terminal (e.g., a second connector 730 of FIG. 7) electrically connected to a second supply circuit outside FEM, the second terminal being configured to provide a second voltage for operating the PA within an operating range, a third terminal (e.g., a third connector 740 of FIG. 7) connected to another PA in another FEM outside the FEM, and a switch (e.g., a first switch 750 of FIG. 7) configured to provide a first electrical connection between the first terminal and the PA in the FEM or a second electrical connection between the second terminal and the PA in the FEM.

According to an example, the third terminal may be configured to provide the first voltage to the another PA in the another FEM, while the first voltage is provided to the PA in the FEM through the first electrical connection from the first power supply circuit.

According to an example, the third terminal may be configured to provide the second voltage to the another PA in the another FEM, while the second voltage is provided to the PA in the FEM through the second electrical connection from the second power supply circuit.

According to an example, the third terminal may be electrically connected to a node of the PA in the FEM to which the first voltage or the second voltage is applied.

According to an example, the FEM may further include another switch distinct from the switch and configured to provide a third electrical connection between the PA in the FEM and the switch or a fourth electrical connection between the switch and the third terminal.

According to an example, the another switch may be configured to refrain from providing the first voltage to the another PA in the another FEM through the fourth electrical connection, while the first voltage is provided from the first power supply circuit through the third electrical connection to the PA in the FEM.

According to an example, the another switch may be configured to refrain from providing the first voltage to the PA in the FEM through the third electrical connection, while the first voltage is provided to the another PA in the another FEM from the first power supply circuit through the fourth electrical connection.

According to an example, the another switch may be configured to refrain from providing the second voltage to the another PA in the another FEM through the fourth electrical connection, while the second voltage is provided to the PA in the FEM from the second power supply circuit through the third electrical connection,

According to an example, the another switch may be configured to refrain from providing the second voltage to the PA in the FEM through the third electrical connection, while the second voltage is provided to the another PA in the another FEM from the second power supply circuit through the fourth electrical connection.

Various examples of the present disclosure include one or more electronic devices according to one or more of the following numbered examples. The skilled person will appreciate that the following examples and features thereof may be combined with any other suitable examples, aspects, embodiments and/or claims disclosed in the present specification and features thereof.

According to an example, an electronic device (101) may comprise a processor (400), a first power supply, PS, (401) and a second PS (402), a third front-end module, FEM, (430) comprising a third power amplifier, PA, (431) for amplifying, based on a control signal, a third RF signal, and a first routing component (490, 750) configured to route, according to control of the processor (400), a selected one of a first control signal output by the first PS (401), and a second control signal output by the second PS (402), to a signal path for providing a control signal to the third FEM (430).

According to an example an electronic device may further comprise a first FEM (410) comprising a first PA (411) for amplifying, based on a control signal output by the first PS (401), a first RF signal, and a second FEM (420) comprising a second PA (421) for amplifying, based on a control signal output by the second PS (402), a second RF signal.

According to example, wherein the third FEM (430) is directly connected to the routing component (490) via the signal path.

According to example, the electronic device may further comprise a fourth FEM (440) comprising a fourth PA (441) for amplifying, based on a control signal transmitted via the signal path, a fourth RF signal.

According to example, wherein the fourth FEM (440) is directly connected to the routing component (490) via the signal path.

According to example the electronic device, may further comprises a second routing component (760) configured to route, according to control of the processor (400), a signal received via the signal path to a selected one of the third FEM (430) and the fourth FEM (440).

According to example, wherein the second routing component (760) is configured to selectively disconnect, according to control of the processor, a signal received via the signal path from the third FEM (430) and the fourth FEM (440).

According to example, wherein the second routing (760) component comprises a switch.

According to example, wherein the second routing (760) component comprises an input node connected to the signal path, a first output node connected to the third FEM (430), and a second output node connected to the fourth FEM (440), wherein the second routing component

(760) is configured to be selectively set to a first routing state in which a signal received at the input node is routed to the first output node, or a second routing state in which a signal received at the input node is routed to the second output node, and wherein the processor (400) is configured to control the routing state of the second routing component (760) to route a control signal transmitted via the signal path to one of the third FEM (430) and the fourth FEM (440).

According to examples, wherein the second routing component (760) is disposed within one of the FEMs (e.g., the third FEM (430)).

According to example, wherein the first routing component (490, 750) comprises a switch.

According to example, wherein the first routing (490, 750) component comprises a first input node connected to the first PS (401), a second input node connected to the second PS (402), and an output node connected to the signal path, wherein the first routing component (490, 750) is configured to be selectively set to a first routing state in which a signal received at the first input node is routed to the output node, or a second routing state in which a signal received at the second input node is routed to the output node, and wherein the processor (400) is configured to control the routing state of the first routing component (490, 750) to route a control signal output by one of the first PS (401) and the second PS (402) as a control signal to the output signal path.

According to example, wherein the first routing component (490, 750) is disposed within one of the FEMs (e.g., the third FEM (430)).

According to example, the electronic device may comprise one or more antennas (A1-A4), wherein each antenna (A1-A4) is configured to be connected to, or selectively connectable to, the output of at least one PA (411, 421, 431, 441).

According to example, wherein the one or more antennas (A1-A4) comprise: first to fourth antennas (A1-A4), connected to the outputs of the first to fourth PAs (411, 421, 431, 441) respectively, and configured for transmitting the first to fourth RF signals respectively.

According to example, wherein at least one of the antennas (A1-A4) is disposed on a side surface (901-904) of a case or housing of the electronic device (101), or is formed from a conductive portion of the side surface (901-904) of the case or housing of the electronic device (101).

According to example, wherein at least some of the antennas (A1-A4) are disposed on different (e.g., opposite or adjacent) side surfaces (901-904) of the case or housing of the electronic device (101).

According to example, wherein at least some of the RF signals differ in their signal characteristics.

According to example, wherein the signal characteristics include frequency characteristics (e.g., frequency bands).

According to example, wherein the processor (400) is configured to control the first and/or second routing components (490, 750, 760) to route a first control signal output by the first PS (401) to the first FEM (410) to transmit a first RF signal, and route a second control signal output by the second PS (402) to at least one of the third FEM (430) and the fourth FEM (440) to transmit at least one of a third RF signal and a fourth RF signal simultaneously with transmitting the first RF signal.

According to example, wherein the processor (400) is configured to control the first and/or second routing components (490, 750, 760) to route a second control signal output by the second PS (402) to the second FEM (420) to transmit a second RF signal, and route a first control signal output by the first PS (401) to at least one of the third FEM (430) and the fourth FEM (440) to transmit at least one of a third RF signal and a fourth RF signal simultaneously with transmitting the second RF signal.

The electronic device according to various embodiments disclosed herein may be one of various types of electronic devices. The electronic devices may include, for example, a portable communication device (e.g., a smartphone), a computer device, a portable multimedia device, a portable medical device, a camera, a wearable device, or a home appliance. According to an example, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may be interchangeably used with other terms, for example, "logic," "logic block," "part," or "circuitry". A module may be a single integral component, or a minimum unit or part thereof, adapted to perform one or more functions. For example, according to an example, the module may be implemented in a form of an application-specific integrated circuit (ASIC).

Various embodiments as set forth herein may be implemented as software (e.g., a program 140) including one or more instructions that are stored in a storage medium (e.g., an internal memory 136 or an external memory 138) that is readable by a machine (e.g., an electronic device 101). For example, a processor (e.g., a processor 120 of an electronic device 101) of the machine may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an example, a method according to various embodiments of the disclosure may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments of the disclosure, each component (e.g., a module or a program) of the above-described components may include a single entity or multiple entities, and some of the multiple entities may be separately disposed in different components. According to various embodiments of the disclosure, one or more of the above-described components may be omitted, or one or more other components may be added. Alternatively or additionally, a plurality of components (e.g., modules or programs) may be integrated into a single component. In such a case, according to various embodiments of the disclosure, the integrated component may still perform one or more functions of each of the plurality of components in the same or similar manner as they are performed by a corresponding one of the plurality of components before the integration. According to various embodiments of the disclosure, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a plurality of power supply circuits including a first power supply circuit (401) and a second power supply circuit (402); and
front-end modules, FEMs, including:
a first FEM (410) connected to the first power supply circuit and including a first power amplifier, PA, (411)
a second FEM (420) connected to the second power supply circuit and including a second PA (421),
a third FEM (430) including a third PA (431) and a first switch (490), and
a fourth FEM (440) including a fourth PA (441); wherein the first power supply circuit and the second power supply circuit are configured to be outside the FEMs;
wherein the first switch is configured to, when in a first state, connect the first power supply circuit to the third PA and the fourth PA and, when in a second state, connect the second power supply circuit to the third PA and the fourth PA,
wherein the first switch is controlled to connect the second power supply circuit to the third PA and the fourth PA so as to transmit a signal using the third PA or the fourth PA operating based on a second voltage provided from the second power supply circuit, while transmitting a signal using the first PA operating based on a first voltage provided from the first power supply circuit, and
wherein the first switch is controlled to connect the first power supply circuit to the third PA and the fourth PA so as to transmit a signal using the third PA or the fourth PA operating based on the first voltage provided from the first power supply circuit, while transmitting a signal using the second PA operating based on the second voltage provided from the second power supply circuit.

2. The electronic device according to claim 1, further comprising a plurality of antennas including a first antenna connected to the first PA, a second antenna connected to the second PA, a third antenna electrically connected to the third PA, and a fourth antenna electrically connected to the fourth PA.

3. The electronic device according to claim 1 or claim 2, wherein the third antenna or the fourth antenna is disposed at one side of the electronic device.

4. The electronic device according to claim 3, further comprising a side wall forming one side surface of the electronic device,
wherein a conductive portion of the side wall disposed at the one side is configured to operate as at least a part of one of the third antenna or the fourth antenna.

5. The electronic device according to any one of the preceding claims, further comprising at least one processor,
wherein the at least one processor is configured to support dual connectivity or carrier aggregation, by transmitting a first RF signal from the first PA and a signal from the third PA or the fourth PA, in the first connection state and or by transmitting a second RF signal and a signal from the third PA or the fourth PA, in the second connection.

6. The electronic device according to any one of the preceding claims, further comprising at least one processor,
wherein the at least one processor is configured to:
receive a control message from a first external electronic device while a signal is transmitted to the first external electronic device using the first PA,
based on the control message, identify a PA for a signal to be transmitted, among the second PA, the third PA and the fourth PA, while the signal is transmitted using the first PA, and
connect the second power supply circuit and the third PA and the fourth PA through the first switch, on condition that the PA is the third PA or the fourth PA.

7. The electronic device according to claim 6,
wherein the signal transmitted using the first PA is transmitted to the first external electronic device according to a first communication scheme, and
wherein the signal transmitted using the PA is transmitted to a second external electronic device, according to a second communication scheme.

8. The electronic device according to claim 7, wherein the at least one processor is configured to:
based on the control message, electrically connect the second power supply circuit with the third PA and the fourth PA through the first switch and inactivate the fourth PA, based on identifying that the PA for a signal to be transmitted to the second external electronic device according to the second communication scheme is the third PA; and
based on the control message, electrically connect the second power supply circuit with the third PA and the fourth PA through the first switch and inactivate the third PA, based on identifying that the PA for signal to be transmitted to the second external electronic device according to the second communication scheme is the fourth PA.

9. The electronic device according to claim 7 or claim 8, wherein the at least one processor is configured to:
based on the control message, refrain from electrically connecting the third PA and the fourth PA with the second power supply circuit through the first switch, based on identifying the PA for the signal to be transmitted to the second external electronic device according to the second communication scheme is the second PA.

10. The electronic device according to any one of claims 1 to 5, wherein the at least one processor is configured to:
receive a control message from a first external electronic device while a signal is transmitted to the first external electronic device using the second PA,
based on the control message, identify a PA for a signal to be transmitted, among the first PA, the third PA, and the fourth PA, while the signal is transmitted using the second PA, and
electrically connect the first power supply circuit with the third PA and the fourth PA through the first switch, on condition that the PA is the third PA or the fourth PA.

11. The electronic device according to claim 10,
wherein the signal transmitted using the second PA is transmitted to the first external electronic device according to a first communication scheme, and
wherein the signal transmitted using the PA among the first PA, the third PA, or the fourth PA is transmitted to a second external electronic device distinct from the first external electronic device according to a second communication scheme distinct from the first communication scheme.

12. The electronic device according to claim 11, wherein the at least one processor is configured to:
based on the control message, electrically connect the third PA and the fourth PA with the power supply circuit through the first switch, based on identifying that a PA for a signal to be transmitted to the second external electronic device according to the second communication scheme is the third PA;
based on the control message, electrically connect the third PA and the fourth PA with the second power supply circuit through the first switch, based on identifying that the PA for the signal to be transmitted to the second external electronic device according to the second communication scheme is the fourth PA; and
based on the control message, refrain from electrically connecting the third PA and the fourth PA with the second power supply circuit through the first switch, based on identifying that the PA for the signal to be transmitted to the second external electronic device according to the second communication scheme is the second PA.

13. The electronic device according to any one of the preceding claims,
wherein the FEMs further include a fifth FEM including a fifth PA connected to the first switch, and
wherein the first switch is controlled to connect both the first power supply circuit and the second power supply circuit to the fifth PA so as to transmit a signal using the fifth PA operating based on the first voltage and the second voltage.

14. A front-end module, FEM, (700) comprising:
a substrate (701);
a power amplifier, PA, (710) disposed on the substrate, configured to set a transmit power of a signal;
a first terminal (720) configured to connect to a first power supply circuit outside the FEM;
a second terminal (730) configured to connect to a second power supply circuit outside the FEM;
a third terminal (740) configured to connect to another PA outside the FEM; and
a switch (750), disposed on the substrate, configured to provide a first connection between the first terminal and the PA in the FEM or a second connection between the second terminal and the PA in the FEM,
wherein the third terminal is connected to a node between the switch and the PA such that an electrical power from the first power supply circuit is provided to the other PA, while the electrical power from the first power supply circuit is provided to the PA in the FEM through the first connection formed using the switch, and an electrical power from the second power supply circuit is provided to the other PA, while the electrical power from the second power supply circuit is provided to the PA in the FEM through the second connection formed using the switch.

15. The FEM according to claim 14, wherein the switch is further configured to provide a third connection to connect both the first terminal and the second terminal to the third terminal.

## Patentansprüche

1. Elektronische Vorrichtung (101), umfassend:
eine Vielzahl von Stromversorgungsschaltungen, die eine erste Stromversorgungsschaltung (401) und eine zweite Stromversorgungsschaltung (402) beinhalten; und
Frontendmodule, FEMs, beinhaltend:
ein erstes FEM (410), das mit der ersten Stromversorgungsschaltung verbunden ist und einen ersten Leistungsverstärker, PA, (411) beinhaltet,
ein zweites FEM (420), das mit der zweiten Stromversorgungsschaltung verbunden ist und einen zweiten PA (421) beinhaltet,
ein drittes FEM (430), das einen dritten PA (431) und einen ersten Schalter (490) beinhaltet, und ein viertes FEM (440), das einen vierten PA (441) beinhaltet;
wobei die erste Stromversorgungsschaltung und die zweite Stromversorgungsschaltung dazu konfiguriert sind, sich außerhalb der FEMs zu befinden;
wobei der erste Schalter dazu konfiguriert ist, wenn er sich in einem ersten Zustand befindet, die erste Stromversorgungsschaltung mit dem dritten PA und dem vierten PA zu verbinden und, wenn er sich in einem zweiten Zustand befindet, die zweite Stromversorgungsschaltung mit dem dritten PA und dem vierten PA zu verbinden,
wobei der erste Schalter so gesteuert wird, dass er die zweite Stromversorgungsschaltung mit dem dritten PA und dem vierten PA verbindet, um ein Signal unter Verwendung des dritten PA oder des vierten PA, der basierend auf einer zweiten Spannung arbeitet, die von der zweiten Stromversorgungsschaltung bereitgestellt wird, zu übertragen, während ein Signal unter Verwendung des ersten PA, der basierend auf einer ersten Spannung arbeitet, die von der ersten Stromversorgungsschaltung bereitgestellt wird, übertragen wird, und
wobei der erste Schalter so gesteuert wird, dass er die erste Stromversorgungsschaltung mit dem dritten PA und dem vierten PA verbindet, um ein Signal unter Verwendung des dritten PA oder des vierten PA, der basierend auf der ersten Spannung arbeitet, die von der ersten Stromversorgungsschaltung bereitgestellt wird, zu übertragen, während ein Signal unter Verwendung des zweiten PA, der basierend auf der zweiten Spannung arbeitet, die von der zweiten Stromversorgungsschaltung bereitgestellt wird, übertragen wird.

2. Elektronische Vorrichtung nach Anspruch 1, ferner umfassend eine Vielzahl von Antennen, die eine erste Antenne, die mit dem ersten PA verbunden ist, eine zweite Antenne, die mit dem zweiten PA verbunden ist, eine dritte Antenne, die elektrisch mit dem dritten PA verbunden ist, und eine vierte Antenne, die elektrisch mit dem vierten PA verbunden ist, beinhaltet.

3. Elektronische Vorrichtung nach Anspruch 1 oder Anspruch 2, wobei die dritte Antenne oder die vierte Antenne an einer Seite der elektronischen Vorrichtung angeordnet ist.

4. Elektronische Vorrichtung nach Anspruch 3, ferner umfassend eine Seitenwand, die eine Seitenfläche der elektronischen Vorrichtung bildet,
wobei ein leitender Abschnitt der Seitenwand, der an der einen Seite angeordnet ist, dazu konfiguriert ist, als mindestens ein Teil von einer von der dritten Antenne oder der vierten Antenne zu arbeiten.

5. Elektronische Vorrichtung nach einem der vorhergehenden Ansprüche, ferner umfassend mindestens einen Prozessor,
wobei der mindestens eine Prozessor dazu konfiguriert ist, duale Konnektivität oder Trägeraggregation zu unterstützen, indem ein erstes HF-Signal von dem ersten PA und ein Signal von dem dritten PA oder dem vierten PA in dem ersten Verbindungszustand übertragen werden und/oder indem ein zweites HF-Signal und ein Signal von dem dritten PA oder dem vierten PA in der zweiten Verbindung übertragen werden.

6. Elektrische Vorrichtung nach einem der vorhergehenden Ansprüche, ferner umfassend mindestens einen Prozessor,
wobei der mindestens eine Prozessor zu Folgendem konfiguriert ist:
Empfangen einer Steuernachricht von einer ersten externen elektronischen Vorrichtung, während ein Signal unter Verwendung des ersten PA an die erste externe elektronische Vorrichtung übertragen wird,
basierend auf der Steuernachricht, Identifizieren eines PA für ein zu übertragendes Signal unter dem zweiten PA, dem dritten PA und dem vierten PA, während das Signal unter Verwendung des ersten PA übertragen wird, und
Verbinden der zweiten Stromversorgungsschaltung und des dritten PA und des vierten PA durch den ersten Schalter, unter der Bedingung, dass der PA der dritte PA oder der vierte PA ist.

7. Elektronische Vorrichtung nach Anspruch 6,
wobei das unter Verwendung des ersten PA übertragene Signal gemäß einem ersten Kommunikationsschema an die erste externe elektronische Vorrichtung übertragen wird und
wobei das unter Verwendung des PA übertragene Signal gemäß einem zweiten Kommunikationsschema an eine zweite externe elektronische Vorrichtung übertragen wird.

8. Elektronische Vorrichtung nach Anspruch 7, wobei der mindestens eine Prozessor zu Folgendem konfiguriert ist:
basierend auf der Steuernachricht, elektrisches Verbinden der zweiten Stromversorgungsschaltung mit dem dritten PA und dem vierten PA durch den ersten Schalter und Inaktivieren des vierten PA, basierend auf dem Identifizieren, dass der PA für ein an die zweite externe elektronische Vorrichtung gemäß dem zweiten Kommunikationsschema zu übertragendes Signal der dritte PA ist; und
basierend auf der Steuernachricht, elektrisches Verbinden der zweiten Stromversorgungsschaltung mit dem dritten PA und dem vierten PA durch den ersten Schalter und Inaktivieren des dritten PA, basierend auf dem Identifizieren, dass der PA für ein an die zweite externe elektronische Vorrichtung gemäß dem zweiten Kommunikationsschema zu übertragendes Signal der vierte PA ist.

9. Elektronische Vorrichtung nach Anspruch 7 oder Anspruch 8, wobei der mindestens eine Prozessor zu Folgendem konfiguriert ist:
basierend auf der Steuernachricht, Unterlassen des elektrischen Verbindens des dritten PA und des vierten PA mit der zweiten Stromversorgungsschaltung durch den ersten Schalter, basierend auf dem Identifizieren, dass der PA für das an die zweite externe elektronische Vorrichtung gemäß dem zweiten Kommunikationsschema zu übertragende Signal der zweite PA ist.

10. Elektronische Vorrichtung nach einem der Ansprüche 1 bis 5, wobei der mindestens eine Prozessor zu Folgendem konfiguriert ist:
Empfangen einer Steuernachricht von einer ersten externen elektronischen Vorrichtung, während ein Signal unter Verwendung des zweiten PA an die erste externe elektronische Vorrichtung übertragen wird,
basierend auf der Steuernachricht, Identifizieren eines PA für ein zu übertragendes Signal unter dem ersten PA, dem dritten PA und dem vierten PA, während das Signal unter Verwendung des zweiten PA übertragen wird, und
elektrisches Verbinden der ersten Stromversorgungsschaltung mit dem dritten PA und dem vierten PA durch den ersten Schalter, unter der Bedingung, dass der PA der dritte PA oder der vierte PA ist.

11. Elektronische Vorrichtung nach Anspruch 10,
wobei das unter Verwendung des zweiten PA übertragene Signal gemäß einem ersten Kommunikationsschema an die erste externe elektronische Vorrichtung übertragen wird und
wobei das unter Verwendung des PA unter dem ersten PA, dem dritten PA oder dem vierten PA übertragene Signal gemäß einem zweiten Kommunikationsschema, das sich von dem ersten Kommunikationsschema unterscheidet, an eine zweite externe elektronische Vorrichtung, die sich von der ersten externen elektronischen Vorrichtung unterscheidet, übertragen wird.

12. Elektronische Vorrichtung nach Anspruch 11, wobei der mindestens eine Prozessor zu Folgendem konfiguriert ist:
basierend auf der Steuernachricht, elektrisches Verbinden des dritten PA und des vierten PA mit der Stromversorgungsschaltung durch den ersten Schalter, basierend auf dem Identifizieren, dass ein PA für ein an die zweite externe elektronische Vorrichtung gemäß dem zweiten Kommunikationsschema zu übertragendes Signal der dritte PA ist;
basierend auf der Steuernachricht, elektrisches Verbinden des dritten PA und des vierten PA mit der zweiten Stromversorgungsschaltung durch den ersten Schalter, basierend auf dem Identifizieren, dass der PA für das an die zweite externe elektronische Vorrichtung gemäß dem zweiten Kommunikationsschema zu übertragende Signal der vierte PA ist; und
basierend auf der Steuernachricht, Unterlassen des elektrischen Verbindens des dritten PA und des vierten PA mit der zweiten Stromversorgungsschaltung durch den ersten Schalter, basierend auf dem Identifizieren, dass der PA für das an die zweite externe elektronische Vorrichtung gemäß dem zweiten Kommunikationsschema zu übertragende Signal der zweite PA ist.

13. Elektronische Vorrichtung nach einem der vorhergehenden Patentansprüche,
wobei die FEMs ferner ein fünftes FEM beinhalten, das einen fünften PA beinhaltet, der mit dem ersten Schalter verbunden ist, und
wobei der erste Schalter so gesteuert wird, dass er sowohl die erste Stromversorgungsschaltung als auch die zweite Stromversorgungsschaltung mit dem fünften PA verbindet, um ein Signal unter Verwendung des fünften PA, der basierend auf der ersten Spannung und der zweiten Spannung arbeitet, zu übertragen.

14. Frontendmodul, FEM, (700), umfassend:
ein Substrat (701);
einen Leistungsverstärker, PA, (710), der auf dem Substrat angeordnet ist und dazu konfiguriert ist, eine Übertragungsleistung eines Signals einzustellen;
einen ersten Anschluss (720), der dazu konfiguriert ist, sich mit einer ersten Stromversorgungsschaltung außerhalb des FEM zu verbinden;
einen zweiten Anschluss (730), der dazu konfiguriert ist, sich mit einer zweiten Stromversorgungsschaltung außerhalb des FEM zu verbinden;
einen dritten Anschluss (740), der dazu konfiguriert ist, sich mit einem anderen PA außerhalb des FEM zu verbinden; und
einen Schalter (750), der auf dem Substrat angeordnet ist und dazu konfiguriert ist, eine erste Verbindung zwischen dem ersten Anschluss und dem PA in dem FEM oder eine zweite Verbindung zwischen dem zweiten Anschluss und dem PA in dem FEM bereitzustellen,
wobei der dritte Anschluss mit einem Knoten zwischen dem Schalter und dem PA verbunden ist, sodass ein elektrischer Strom von der ersten Stromversorgungsschaltung an den anderen PA bereitgestellt wird, während der elektrische Strom von der ersten Stromversorgungsschaltung an den PA in dem FEM durch die erste Verbindung bereitgestellt wird, die unter Verwendung des Schalters gebildet wird, und ein elektrischer Strom von der zweiten Stromversorgungsschaltung an den anderen PA bereitgestellt wird, während der elektrische Strom von der zweiten Stromversorgungsschaltung an den PA in dem FEM durch die zweite Verbindung bereitgestellt wird, die unter Verwendung des Schalters gebildet wird.

15. FEM nach Anspruch 14, wobei der Schalter ferner dazu konfiguriert ist, eine dritte Verbindung bereitzustellen, um sowohl den ersten Anschluss als auch den zweiten Anschluss mit dem dritten Anschluss zu verbinden.

## Revendications

1. Dispositif électronique (101) comprenant :
une pluralité de circuits d'alimentation comprenant un premier circuit d'alimentation (401) et un second circuit d'alimentation (402) ; et
des modules d'extrémité avant, FEM, comprenant :
un premier FEM (410) relié au premier circuit d'alimentation et comprenant un premier amplificateur de puissance, PA, (411)
un deuxième FEM (420) relié au second circuit d'alimentation et comprenant un deuxième PA (421),
un troisième FEM (430) comprenant un troisième PA (431) et un premier commutateur (490), et un quatrième FEM (440) comprenant un quatrième PA (441) ; dans lequel le premier circuit d'alimentation et le second circuit d'alimentation sont configurés pour être à l'extérieur des FEM ;
dans lequel le premier commutateur est configuré pour, lorsqu'il est dans un premier état, connecter le premier circuit d'alimentation au troisième PA et au quatrième PA et, lorsqu'il est dans un second état, connecter le second circuit d'alimentation au troisième PA et au quatrième PA,
dans lequel le premier commutateur est commandé pour connecter le second circuit d'alimentation au troisième PA et au quatrième PA de façon à transmettre un signal utilisant le troisième PA ou le quatrième PA fonctionnant sur la base d'une seconde tension fournie par le second circuit d'alimentation, tout en transmettant un signal à l'aide du premier PA fonctionnant sur la base d'une première tension fournie par le premier circuit d'alimentation, et
dans lequel le premier commutateur est commandé pour connecter le premier circuit d'alimentation au troisième PA et au quatrième PA de façon à transmettre un signal à l'aide du troisième PA ou du quatrième PA fonctionnant sur la base de la première tension fournie par le premier circuit d'alimentation, tout en transmettant un signal à l'aide du deuxième PA fonctionnant sur la base de la seconde tension fournie par le second circuit d'alimentation.

2. Dispositif électronique selon la revendication 1, comprenant en outre une pluralité d'antennes comprenant une première antenne connectée au premier PA, une deuxième antenne connectée au deuxième PA, une troisième antenne connectée électriquement au troisième PA et une quatrième antenne connectée électriquement au quatrième PA.

3. Dispositif électronique selon la revendication 1 ou la revendication 2, dans lequel la troisième antenne ou la quatrième antenne est disposée d'un côté du dispositif électronique.

4. Dispositif électronique selon la revendication 3, comprenant en outre une paroi latérale formant une surface latérale du dispositif électronique,
dans lequel une partie conductrice de la paroi latérale disposée d'un côté est configurée pour fonctionner en tant qu'au moins une partie de la troisième antenne ou de la quatrième antenne.

5. Dispositif électronique selon l'une quelconque des revendications précédentes, comprenant en outre au moins un processeur,
dans lequel l'au moins un processeur est configuré pour prendre en charge une double connectivité ou une agrégation de porteuses, en transmettant un premier signal RF à partir du premier PA et un signal à partir du troisième PA ou du quatrième PA, dans le premier état de connexion et/ou en transmettant un second signal RF et un signal à partir du troisième PA ou du quatrième PA, dans la deuxième connexion.

6. Dispositif électronique selon l'une quelconque des revendications précédentes, comprenant en outre au moins un processeur,
dans lequel l'au moins un processeur est configuré pour :
recevoir un message de commande provenant d'un premier dispositif électronique externe pendant qu'un signal est transmis au premier dispositif électronique externe à l'aide du premier PA,
sur la base du message de commande, identifier un PA pour transmettre un signal, parmi le deuxième PA, le troisième PA et le quatrième PA, pendant que le signal est transmis à l'aide du premier PA, et
connecter le second circuit d'alimentation et le troisième PA et le quatrième PA au travers du premier commutateur, à condition que le PA soit le troisième PA ou le quatrième PA.

7. Dispositif électronique selon la revendication 6,
dans lequel le signal transmis à l'aide du premier PA est transmis au premier dispositif électronique externe selon un premier schéma de communication, et
dans lequel le signal transmis à l'aide du PA est transmis à un second dispositif électronique externe, selon un second schéma de communication.

8. Dispositif électronique selon la revendication 7, dans lequel l'au moins un processeur est configuré pour :
sur la base du message de commande, connecter électriquement le second circuit d'alimentation au troisième PA et au quatrième PA au travers du premier commutateur et désactiver le quatrième PA, sur la base de l'identification du fait que le PA pour transmettre un signal au second dispositif électronique externe selon le second schéma de communication est le troisième PA ; et
sur la base du message de commande, connecter électriquement le second circuit d'alimentation au troisième PA et au quatrième PA au travers du premier commutateur et désactiver le troisième PA, sur la base de l'identification du fait que le PA pour transmettre un signal au second dispositif électronique externe selon le second schéma de communication est le quatrième PA.

9. Dispositif électronique selon la revendication 7 ou la revendication 8, dans lequel l'au moins un processeur est configuré pour :
sur la base du message de commande, s'abstenir de connecter électriquement le troisième PA et le quatrième PA au second circuit d'alimentation au travers du premier commutateur, sur la base de l'identification du fait que le PA pour transmettre le signal au second dispositif électronique externe selon le second schéma de communication est le deuxième PA.

10. Dispositif électronique selon l'une quelconque des revendications 1 à 5, dans lequel l'au moins un processeur est configuré pour :
recevoir un message de commande provenant d'un premier dispositif électronique externe pendant qu'un signal est transmis au premier dispositif électronique externe à l'aide du deuxième PA,
sur la base du message de commande, identifier un PA pour transmettre un signal, parmi le premier PA, le troisième PA et le quatrième PA, pendant que le signal est transmis à l'aide du deuxième PA, et
connecter électriquement le premier circuit d'alimentation au troisième PA et au quatrième PA au travers du premier commutateur, à condition que le PA soit le troisième PA ou le quatrième PA.

11. Dispositif électronique selon la revendication 10,
dans lequel le signal transmis à l'aide du deuxième PA est transmis au premier dispositif électronique externe selon un premier schéma de communication, et
dans lequel le signal transmis à l'aide du PA entre le premier PA, le troisième PA ou le quatrième PA est transmis à un second dispositif électronique externe distinct du premier dispositif électronique externe selon un second schéma de communication distinct du premier schéma de communication.

12. Dispositif électronique selon la revendication 11, dans lequel l'au moins un processeur est configuré pour :
sur la base du message de commande, connecter électriquement le troisième PA et le quatrième PA au circuit d'alimentation au travers du premier commutateur, sur la base de l'identification du fait qu'un PA pour transmettre un signal au second dispositif électronique externe selon le second schéma de communication est le troisième PA ;
sur la base du message de commande, connecter électriquement le troisième PA et le quatrième PA au second circuit d'alimentation au travers du premier commutateur, sur la base de l'identification du fait que le PA pour transmettre un signal au second dispositif électronique externe selon le second schéma de communication est le quatrième PA ; et
sur la base du message de commande, s'abstenir de connecter électriquement le troisième PA et le quatrième PA au second circuit d'alimentation au travers du premier commutateur, sur la base de l'identification du fait que le PA pour transmettre le signal au second dispositif électronique externe selon le second schéma de communication est le deuxième PA.

13. Dispositif électronique selon l'une quelconque des revendications précédentes,
dans lequel les FEM comprennent en outre un cinquième FEM comprenant un cinquième PA connecté au premier commutateur, et
dans lequel le premier commutateur est commandé pour connecter à la fois le premier circuit d'alimentation et le second circuit d'alimentation au cinquième PA de façon à transmettre un signal à l'aide du cinquième PA fonctionnant sur la base de la première tension et de la seconde tension.

14. Module d'extrémité avant, FEM, (700) comprenant :
un substrat (701) ;
un amplificateur de puissance, PA, (710) disposé sur le substrat, configuré pour régler une puissance de transmission d'un signal ;
une première borne (720) configurée pour se connecter à un premier circuit d'alimentation en dehors du FEM ;
une deuxième borne (730) configurée pour se connecter à un second circuit d'alimentation à l'extérieur du FEM ;
une troisième borne (740) configurée pour se connecter à un autre PA en dehors du FEM ; et
un commutateur (750), disposé sur le substrat, configuré pour fournir une première connexion entre la première borne et le PA dans le FEM ou une deuxième connexion entre la deuxième borne et le PA dans le FEM,
dans lequel la troisième borne est connectée à un nœud entre le commutateur et le PA de sorte qu'une puissance électrique provenant du premier circuit d'alimentation est fournie à l'autre PA, pendant que la puissance électrique provenant du premier circuit d'alimentation est fournie au PA dans le FEM au travers de la première connexion formée à l'aide du commutateur, et une puissance électrique provenant du second circuit d'alimentation est fournie à l'autre PA, tandis que la puissance électrique provenant du second circuit d'alimentation est fournie au PA dans le FEM au travers de la deuxième connexion formée à l'aide du commutateur.

15. FEM selon la revendication 14, dans lequel le commutateur est en outre configuré pour fournir une troisième connexion pour connecter à la fois la première borne et la deuxième borne à la troisième borne.
